Europäisches Patentamt

European Patent Office

Office européen des brevets

(19)

(11) Veröffentlichungsnummer : **0 092 676**
B1

(12) . # EUROPÄISCHE PATENTSCHRIFT

(45) Veröffentlichungstag der Patentschrift :
21.01.87

(21) Anmeldenummer : 83102782.6

(22) Anmeldetag : 21.03.83

(51) Int. Cl.⁴ : **G 04 F 10/00, G 01 R 25/00**

(54) Zeitmessverfahren und Vorrichtung zu seiner Durchführung.

(30) Priorität : 28.04.82 DE 3215847

(43) Veröffentlichungstag der Anmeldung :
02.11.83 Patentblatt 83/44

(45) Bekanntmachung des Hinweises auf die Patenterteilung : 21.01.87 Patentblatt 87/04

(84) Benannte Vertragsstaaten :
CH FR GB IT LI NL SE

(56) Entgegenhaltungen :
DE-A- 2 855 819
DE-A- 3 012 186
FR-A- 2 437 648
INSTRUMENTS AND EXPERIMENTAL TECHNIQUES,
Band 24, Nr. 1, part 1, Januar/Febuar 1981, Seiten 78-
83, New York (USA); S. V. DENBNOVETSKII et al.:
"Interpolating time interval meter based on elektronika B3-21 calculator"

(73) Patentinhaber : **MTC Messtechnik und Optoelektronik
AG
Avenue Jean Jacques Rousseau 5
CH-2000 Neuchâtel (CH)**

(72) Erfinder : **Bölkow, Ludwig, Dr.
Oberfeldallee 9
D-8022 Grünwald (DE)**
Erfinder : **Mehnert, Walter, Dr.
Grillparzerstrasse 6
D-8012 Ottobrunn (DE)**
Erfinder : **Chaborski, Hoiko
Englschalkinger Strasse 239E
D-8000 München 81 (DE)**

(74) Vertreter : **Strasser, Wolfgang, Dipl.-Phys et al
Patentanwälte Strohschänk, Uri & Strasser Innere
Wiener Strasse 8
D-8000 München 80 (DE)**

## Beschreibung

Die Erfindung betrifft ein Zeitmeßverfahren und eine Vorrichtung zu seiner Durchführung gemäß den Oberbegriffen der Ansprüche 1 und 12.

Bei einem derartigen, beispielsweise aus der DE-A-30 12 186 bekannten Zeitmeßverfahren sind sowohl die Einzelsignale der ersten Signalgruppe als auch die Einzelsignale der zweiten Signalgruppe Zeitmarkensignale, wobei die gleichbleibenden zeitlichen Abstände zwischen jeweils einem Einzelsignal der einen und einem Einzelsignal der anderen Signalgruppe möglichst genau bestimmt werden sollen. Die betreffenden Meßwerte werden nicht unmittelbar sondern rechnerisch aus jeweils drei Einzelmeßwerten, einem sogenannten Grobmeßwert und zwei sogenannten Feinmeßwerten gewonnen. Dabei ergibt sich der Grobmeßwert durch Abzählung der zwischen den beiden Zeitmarkensignalen aufgetretenen Perioden eines Zeitbasissignals, das von einem freilaufenden, d. h. mit den beiden Zeitmarkensignalen in keiner Weise korrelierten oder synchronisierten, quarzgesteuerten Oszillator geliefert wird. Die beiden Feinmeßwerte, die jeweils den zeitlichen Abstand des früheren bzw. späteren Zeitmarkensignals zu einer nachfolgenden, z. B. zur nächsten steigenden Flanke des Zeitbasissignals angeben, werden mit Hilfe ein und derselben Zeit/Amplituden-Wandlerschaltung auf analogem Wege gemessen und nach einer erfolgten Analog/Digital-Wandlung mit dem Grobmeßwert zur Berechnung des interessierenden Gesamtmeßwertes vorzeichenrichtig kombiniert. Im Normalfall bedeutet dies, daß der eine der beiden Feinmeßwerte zum Grobmeßwert addiert und der andere vom Grobmeßwert subtrahiert wird, so daß insgesamt die Differenz der beiden Feinmeßwerte, d. h. also der Zeitabstände, die das erste und das zweite Zeitmarkensignal von einer definierten Flanke des periodischen Zeitbasissignals aufweisen, in das eigentlich interessierende Meßergebnis eingeht. Dabei können statt der steigenden auch die fallenden Flanken des rechteckförmigen Zeitbasissignals oder entsprechende Nulldurchgänge eines sinusförmigen Zeitbasissignals als Bezugspunkte dienen.

Ein typisches Anwendungsbeispiel für dieses bekannte Zeitmeßverfahren stellen beispielsweise Entfernungsmeßverfahren nach dem Prinzip der Laufzeitmessung eines Lichtimpulses dar, bei denen der von einer Sende-Lichtquelle emittierte Lichtimpuls innerhalb des Meßgerätes in einen Meßlichtimpuls und einen Referenzlichtimpuls aufgeteilt wird, wobei ersterer über die Sendeoptik zum Zielgegenstand emittiert, von dort zum Meßgerät reflektiert und im Meßgerät auf einen Lichtempfänger geleitet wird, der zuvor über einen kurzen, geräteinternen Referenzlichtweg bekannter Länge den Referenzlichtimpuls erhalten hat. Beide Lichtimpulse lösen in der dem Lichtempfänger folgenden Auswerteschaltung zwei Signale aus, die die Zeitmarkensignale des oben beschriebenen Zeitmeßverfahrens darstellen und deren zeitlicher Abstand ein Maß für die Entfernung des Zielgegenstandes ist. Wegen der normalerweise unterschiedlichen Länge des Referenzlichtweges und des Meßlichtweges unterliegt jedes dieser beiden zunächst gleichzeitig erzeugten Einzelsignale einer eigenen Grundverzögerung, die sich von der des anderen Signals unterscheidet. Solange sich jedoch die Entfernung zwischen dem Zielgegenstand und dem Entfernungsmeßgerät nicht ändert, bleiben auch die Grundverzögerungen dieser beiden Signale bei einer wiederholten Lichtimpuls-Erzeugung unverändert.

Eine andere Anwendungsmöglichkeit für ein solches Zeitmeßverfahren stellt die Messung der Phasenverschiebung zwischen zwei periodischen Signalen derselben Frequenz dar. Nimmt man beispielsweise an, daß es sich dabei um periodische Rechtecksignale handelt, so bilden die steigenden Flanken des einen periodischen Signals die Einzelsignale der einen Signalgruppe und die steigenden Flanken des anderen periodischen Signals die Einzelsignale der anderen Signalgruppe. Die Phasenverschiebung zwischen den beiden periodischen Signalen kann dadurch gemessen werden, daß man jeweils die Zeitabstände der Einzelsignale sowohl der einen als auch der anderen Signalgruppe zu einer nachfolgenden definierten, beispielsweise der nächsten steigenden Flanke eines dieselbe Frequenz besitzenden Zeitbasissignals mißt, wobei dann wieder die Differenz dieser beiden Zeitabstände in das interessierende Meßergebnis eingeht. Der wesentliche Unterschied zu dem aus der DE-A-30 12 186 bekannten Zeitmeßverfahren besteht hier daring, daß nur die beiden sogenannten Feinmeßwerte, nicht aber ein Grobmeßwert ermittelt werden. Die Summe der unterschiedlichen Grundverzögerungen, denen die Einzelsignale der beiden Signalgruppen vor der Zeitmessung unterworfen sind, ergibt die zu messende Phasenverschiebung. Dabei müssen diese beiden Grundverzögerungen nicht dadurch entstanden sein, daß die beiden periodischen Signale gleichzeitig, d. h. ohne Phasenverschiebung erzeugt worden sind und dann Wege unterschiedlicher Länge durchlaufen haben. Stattdessen können die unterschiedlichen Grundverzögerungen den beiden periodischen Signalen auch von Anfang an, d. h. bereits bei ihrer Erzeugung aufgeprägt sein.

Darüber hinaus sind noch weitere Anwendungsfälle für Zeitmeßverfahren der eingangs genannten Art denkbar, denen jedoch allen gemeinsam ist, daß zwei im allgemeinen unterschiedliche Zeitabstände, die die Einzelsignale einer ersten Signalgruppe und die Einzelsignale einer zweiten Signalgruppe jeweils von einer definierten nachfolgenden oder vorausgehenden steigenden (oder fallenden) Flanke eines rechteckförmigen Zeitbasissignals oder einem nachfolgenden oder vorausgehenden definierten Nulldurchgang eines sinusförmigen Zeitbasissignals aufweisen, gemessen werden, und daß ihre Differenz zur Gewinnung eines weiteren Meßwertes verarbeitet werden soll. Dabei wird vorausgesetzt, daß die Differenz zwischen den Zeitabständen der Einzelsignale der ersten Signalgruppe und den Zeitabständen der Einzelsignale der zweiten Signalgruppe zu dem entsprechenden Punkt des Zeitbasissignals während der Zeitraums, in denen die beiden Signalgruppen erzeugt werden, unverändert bleibt. Gemessen werden die Zeitabstände mit ein und derselben Zeit/Amplituden-Wandlerschaltung, wobei dann, wenn die voneinander zu subtrahierenden Meßwerte genügend rasch hintereinander gewonnen werden, nicht nur Lang- und mittelfristige Drifterscheinungen, sondern auch kurzfristige Schwankungen durch die Differenzbildung herausfallen. Dabei ist es allerdings erforderlich, zur Beseitigung von Schwankungs- und Drifterscheinungen des Kennlinienverlaufs der Zeit/Amplituden-Wandlerschaltung diese Schaltung ständig mit Hilfe eines Eichnormals nachzueichen, wozu sich beispielsweise dann, wenn das Zeitbasissignal mit Hilfe eines quarzgesteuerten Oszillators erzeugt wird, die Periodenlänge des Zeitbasissignals gut eignet. Allerdings können damit nur einzelne Punkte der Zeit/Amplituden-Wandlerschaltung-Kennlinie erfaßt werden, die jeweils genau um eine Periodenlänge des Zeitbasissignals voneinander beabstandet liegen.

Dabei ergibt sich das Problem, daß die Kennlinie der Zeit/Amplituden-Wandlerschaltung zwischen den Eich-Meßpunkten so starke Nichtlinearitäten aufweisen kann, daß es bei der Messung der Zeitabstände von zwei Einzelsignalen mit nachfolgender Differenzbildung zumindest dann, wenn eine sehr hohe Genauigkeit verlangt wird, zu unerlaubt großen Fehlern kommen kann, da die beiden Meßwerte im allgemeinen zwischen den Eich-Meßpunkten an verschiedenen Stellen der Kennlinie der Zeit/Amplituden-Wandlerschaltung liegen, so daß sie unterschiedliche und sich damit bei der Subtraktion nicht mehr gegenseitig aufhebende, durch die Nichtlinearität der Kennlinie bedingte Fehleranteile enthalten.

Eine Möglichkeit zur Verringerung dieser Fehler besteht darin, die Einzelsignale der beiden Signalgruppen in mit dem Zeitbasissignal völlig unkorrelierter Weise so häufig zu erzeugen, daß der sich bei einer nachfolgenden Mittelwertbildung ergebende Fehler des Mittelwertes nach dem Wurzelgesetz der Fehlertheorie unter die geforderte Genauigkeitsgrenze absinkt.

Bei sehr starken Nichtlinearitäten der Kennlinie der Zeit/Amplituden-Wandlerschaltung bzw. bei einer sehr hohen geforderten Meßgenauigkeit kann hierfür allerdings eine außerordentlich große Anzahl von Einzelsignalen erforderlich sein, was dazu führt, daß der Zeitraum, der zur Gewinnung eines entsprechend genauen End-Meßergebnisses erforderlich ist, sehr lang wird. Insbesondere bei Entfernungsmeßverfahren, bei denen die Entfernung von sich schnell bewegenden Gegenständen gemessen werden soll, steht ein solcher langer Meßzeitraum nicht zur Verfügung, da sich ja während dieses Zeitraumes die Differenz der Abstände der Einzelsignale von den definierten Punkten des Zeitbasissignals nicht verändern darf.

Eine zweite Möglichkeit, die aufgrund der Nichtlinearität der Kennlinie der Zeit/Amplituden-Wandlerschaltung auftretenden Fehler zu verringern, ist in Instruments and Experimental Techniques, Bd. 24, Nr. 1, part 1, Jan./Feb. 1981, S. 78 bis 83 beschrieben. Dabei wird der interessierende nichtlineare Kennlinienbereich der Zeit/Amplituden-Wandlerschaltung durch $n + 1$ Eichwerte abgestützt, zwischen denen dann wieder jeweils linear interpoliert wird. Voraussetzung hierfür ist jedoch, daß ein Eichnormal zur Verfügung steht, mit dessen Hilfe die $n + 1$ Eichwerte mit der erforderlichen Genauigkeit und einem hohen Auflösungsvermögen gewonnen werden können. Es werden bei diesem Eichvorgang Standard-Zeitabschnitte erzeugt, die sich in Phase mit Zählimpulsen befinden und schrittweise um einen feststehenden Betrag erhöht werden. Der Einfluß von Nichtlinearitäten zwischen zwei einander unmittelbar benachbarten Eichwerten kann mit diesem bekannten Verfahren nicht beseitigt werden.

Aus der FR-A-2 437 648 ist es bekannt, nach der Messung des Zeitabstandes von zwei von außen kommenden, mit dem Zeitbasissignal nicht korrelierten Signalen, von denen das eine als Start-Signal und das andere als Stopp-Signal bezeichnet wird, geräteintern gleichzeitig und in phasenstarrer Korrelation mit dem Zeitbasissignal ein Start- und ein Stopp-Signal zu erzeugen, um die Laufzeitunterschiede in den beiden getrennten Verarbeitungskanälen für die Start- und Stopp-Signale zu messen und hieraus einen Korrekturwert für die unmittelbar vorausgehende Zeitabstandsmessung zu gewinnen. Eine Erfassung der Nichtlinearitäten der auch hier verwendeten Zeit/Amplituden-Wandlerschaltungen und/oder eine Beseitigung ihres nachteiligen Einflusses auf die Meßgenauigkeit ist hierdurch jedoch nicht möglich.

Demgegenüber liegt der Erfindung die Aufgabe zugrunde, ein Verfahren und eine Vorrichtung der eingangs genannten Art so weiterzubilden, daß trotz des Vorhandenseins unbekannter Nichtlinearitäten zwischen zwei einander benachbarten Eichwerten der Kennlinie der Zeit/Amplituden-Wandlerschaltung Meßergebnisse mit sehr hoher Genauigkeit innerhalb sehr kurzer Zeiträume gewonnen werden können.

Zur Lösung dieser Aufgabe sieht die Erfindung die in den Ansprüchen 1 und 12 niedergelegten Merkmale vor.

Durch die erfindungsgemäßen Maßnahmen werden ähnlich wie bei der oben erwähnten statistischen Lösungsmöglichkeit die durch die Nichtlinearitäten der Kennlinie der Zeit/Amplituden-Wandlerschaltung bedingten, bei Einzelmessungen auftretenden, untolerierbar großen Meßfehler dadurch in der erforderlichen Weise werkleinert, daß mehrere, nämlich n Messungen für jede der beiden Signalgruppen durchgeführt und aus den Meßergebnissen Mittelwerte gebildet werden. Anders als bei der statistischen Fehlerverringerung, die ja nur dann wirksam wird, wenn das Zeitbasissignal mit den Einzelsignalen in keiner Weise korreliert ist, so daß sich bei jeder Einzelmessung andere, in ihrer Größe statistisch verteilte und somit auch mit Fehlern unterschiedlicher Größe behaftete Meßwerte ergeben, wird bei dem erfindungsgemäßen Verfahren für eine Kopplung zwischen der Erzeugung der Einzelsignale und dem Zeitbasissignal gesorgt. Ohne weitere Maßnahmen würde dies zur Folge haben, daß für alle Einzelsignale einer Signalgruppe jeweils derselbe Zeitabstandswert gemessen würde, der auch immer mit demselben Nichtlinearitätsfehler behaftet wäre, so daß sich hierdurch noch keine Steigerung der Meßgenauigkeit ergeben könnte. Dadurch aber, daß gemäß der Erfindung nur ein Einzelsignal einer jeden Signalgruppe der Zeit/Amplituden-Wandlerschaltung « unverzögert », d. h. ohne eine zu der « natürlicherweise », z. B. aufgrund einer Signallaufzeit vorhandenen Grundverzögerung hinzukommende wesentliche weitere Verzögerung zugeführt wird, jedes weitere der n — 1 Einzelsignale derselben Signalgruppe aber gezielt zusätzlich verzögert wird, wobei der Wert dieser zusätzlichen Verzögerung bei jedem der n — 1 Einzelsignale ein anderer ist, erhält man bei jeder Messung für die Einzelsignale einer Signalgruppe jeweils einen anderen Meßwert, von denen jeder· mit einem anderen Nichtlinearitätsfehler behaftet ist. Durch geeignete Wahl der einzelnen n — 1 Verzögerungswerte wird erfindungsgemäß dafür gesorgt, daß für eine Signalgruppe n Meßwerte erhalten werden, die gleichmäßig, d. h. in etwa äquidistant über den gesamten geeichten Kennlinienbereich der Zeit/Amplituden-Wandlerschaltung verteilt sind, so daß alle durch die Nichtlinearität der Zeit/Amplituden-Wandlerschaltungs-Kennlinie möglichen Fehlerbeiträge in etwa gleichmäßig erfaßt werden. Da dasselbe dann auch bei den n Einzelsignalen der anderen Signalgruppe geschieht, wobei vorzugsweise jeder der n — 1 verschiedenen, bei der ersten Signalgruppe verwendeten Verzögerungswerte ein zweites Mal zum Einsatz kommt, sind in den beiden voneinander abzuziehenden Meßwertgruppen die Nichtlinearitätsfehler mit sehr guter Näherung in gleicher Weise enthalten, so daß sie bei der nachfolgenden Subtraktion und Mittelwertbildung weitgehend herausfallen. Dabei ist es völlig gleichgültig, ob man zuerst die Differenzen zwischen jeweils zwei zusammengehörigen, d. h. mit Hilfe desselben Verzögerungswertes erzeugten Meßwerten, von denen der eine aus der einen und der andere aus der anderen Signalgruppe stammt, und dann den Mittelwert dieser Differenzen bildet, oder ob zuerst die Mittelwerte der Meßwerte einer jeden Signalgruppe gebildet und dann diese Mittelwerte voneinander abgezogen werden.

Ein wesentlicher Vorteil des erfindungsgemäßen Verfahrens gegenüber der oben erwähnten statistischen Fehlerverkleinerung besteht darin, daß jede der Signalgruppen eine erheblich geringere Anzahl von Einzelsignalen umfassen muß, sodaß wesentlich schneller sehr genaue Meßergebnisse erhalten werden. So hat sich gezeigt, daß es beispielsweise mit $n = 8$ möglich ist, bei einem geeichten Kennlinienbereich von 66,7 ns Länge (entsprechend der Periodenlänge eines Zeitbasissignals von 15 MHz) mit einer vergleichsweise einfachen Zeit/Amplituden-Wandlerschaltung, bei der für die Linearisierung der Kennlinie kein besonderer schaltungstechnischer Aufwand getrieben worden ist, den durch Nichtlinearitäten des geeichten Kennlinienbereiches bedingten Fehler auf weniger als $10^{-4}$ zu drücken. Führt man die Eichung der Kennlinie der Zeit/Amplituden-Wandlerschaltung mit Hilfe eines von einem quarzgesteuerten Oszillator abgegebenen periodischen Signals beispielsweise der oben angegebenen Frequenz durch, so läßt sich insgesamt eine Genauigkeit von $10^{-11}$ und besser erreichen, wobei der Meßfehler kleiner als 10 ps wird.

Ein besonderer Vorteil des erfindungsgemäßen Verfahrens ist darin zu sehen, daß es mit der eben geschilderten Genauigkeit auch dann funktioniert, wenn die Kennlinie der Zeit/Amplituden-Wandlerschaltung im geeichten Bereich nur nach einer Seite hin vom ideal linearen Verlauf abweicht, d. h. systematisch nur zu große oder zu kleine Werte liefert. Zur Vermeidung von zu häufigen Umschaltvorgängen können zuerst die Einzelsignale der einen Signalgruppe und erst dann die Einzelsignale der anderen Signalgruppe erzeugt und jeweils den verschiedenen Verzögerungen unterworfen werden. Die Voraussetzung, die hierfür erfüllt sein muß, ist, daß es möglich ist, die beiden Signalgruppen innerhalb eines Zeitraumes zu erzeugen, der so klein ist, daß sich in ihm keine die Meßgenauigkeit beeinflussenden Änderungen der Verzögerungswerte ergeben, denen die Einzelsignale nach dem erfindungsgemäßen Verfahren unterworfen werden.

Läßt sich die Konstanz der Verzögerungswerte nicht über einen für die Erzeugung und Ausmessung von zwei kompletten Signalgruppen erforderlichen Zeitraum hinweg aufrechterhalten, so ist es vorteilhaft, gemäß einer Weiterbildung der Erfindung alternierend immer ein Signal der einen Signalgruppe und ein Signal der anderen Signalgruppe zu erzeugen und diese zwei aufeinanderfolgenden Signale derselben Verzögerung zu unterwerfen.

Eine weitere Steigerung der Meßgenauigkeit ist gemäß einer anderen Weiterbildung dadurch möglich, daß die Einzelsignale der beiden Signalgruppen so erzeugt werden, daß die Zeit/Amplituden-Wandlerschaltung möglichst genau periodisch betrieben wird. Der Kennlinienverlauf der Zeit/Amplituden-Wandlerschaltung ist dann in besonders gutem Maße reproduzierbar, so daß sich die bei den Einzelmessungen jeweils vorhandenen Fehler bei der Mittelwert- und Differenzbildung noch besser herausheben, als dies bei einem aperiodischen Betrieb der Zeit/Amplituden-Wandlerschaltung der Fall ist. Werden zwischen den Einzelsignalmessungen Eichmessungen durchgeführt, so werden vorteilhafterweise auch diese Eichmessungen so gesteuert, daß sich zumindest über eine Signalgruppe hinweg ein periodischer Betrieb der Zeit/Amplituden-Wandlerschaltung ergibt, der dann auch bei der anderen Signalgruppe mit der gleichen Frequenz durchgeführt wird.

Ein besonders einfacher Aufbau und eine besonders einfache Steuerung der zur Erzeugung der verschiedenen Verzögerungswerte dienenden Verzögerungsanordnung für die Einzelsignale ergibt sich dann, wenn die $n - 1$ gewählten Verzögerungswerte jeweils in etwa ein ganzzahliges Vielfaches einer Einheits-Verzögerung $\tau 0$ bilden, und die Verzögerungen, denen die $n - 1$ Signale einer Signalgruppe unterworfen werden, in steigender oder fallender Reihe angeordnet werden, so daß also beispielsweise das erste von n Signalen unverzögert, das zweite mit einer Verzögerung $\tau_0$, das dritte mit einer Verzögerung $2 \times \tau_0$, usw., oder in umgekehrter Reihenfolge der Zeit/Amplituden-Wandlerschaltung zugeführt wird. Die Gleichheit der pro Verzögerungsstufe der steuerbaren Verzögerungsanordnung erzielbaren Verzögerungswerte $\tau_0$ ist zwar von Vorteil, aber nicht besonders kritisch. Abweichungen in der Größenordnung von $\pm 30\%$ sind zur Erzielung der oben angegebenen Genauigkeit ohne weiteres tolerierbar.

Es wurde bereits darauf hingewiesen, daß es zweckmäßig ist, die Kennlinie der Zeit/Amplituden-Wandlerschaltung mit Hilfe der Periodenlänge des Zeitbasissignals zu eichen, das vorteilhafterweise von einem quarzgesteuerten Oszillator geliefert wird. Zu diesem Zweck sind gemäß einer Weiterbildung der Erfindung zwei verschiedene Arten von Eichmessungen vorgesehen, wobei bei jeder Eichmessung die Zeit/Amplituden-Wandlerschaltung durch eine als Startsignal dienende Flanke (oder Sinus-Nulldurchgang) des Zeitbasissignals gestartet und eine nachfolgende, als Stopp-Signal dienende Flanke (oder Sinus-Nulldurchgang) des Zeitbasissignals wieder angehalten wird. Die beiden Arten von Eichmessungen unterscheiden sich dabei dadurch, daß die der Zeit/Amplituden-Wandlerschaltung tatsächlich zugeführten Start- und Stopp-Signale unterschiedlich weit, beispielsweise bei der einen Art von Eichmessungen drei Periodenlängen des Zeitbasissignals und bei der anderen Art von Eichmessungen vier Periodenlängen des Zeitbasissignals voneinander beabstandet sind. Die beiden so gewonnenen « Endpunkte » spannen den geeichten Bereich der Kennlinie der Zeit/Amplituden-Wandlerschaltung auf. Es ist vorteilhaft, bei den Eichmessungen der ersten Art, so wie dies oben angegeben wurde, einen von Null verschiedenen Zeitabstand zwischen Start- und Stopp-Signal für die Zeit/Amplituden-Wandlerschaltung zu wählen und auch bei den eigentlichen Zeitabstandsmessungen, bei denen die Zeit/Amplituden-Wandlerschaltung durch das Einzelsignal gestartet wird, nicht sofort die nächste, sondern erst eine entsprechend spätere steigende (oder fallende) Flanke des Zeitbasissignals als Stopp-Signal zu verwenden, weil auf diese Weise Störungen, die beim Einschalten der Zeit/Amplituden-Wandlerschaltung unvermeidlich auftreten, in alle Meßergebnisse, d. h. vor allem auch die Meßergebnisse für Einzelsignale, die sehr kurz vor der nächsten steigenden (oder fallenden) Flanke des Zeitbasissignals auftreten, in gleicher Weise eingehen und dadurch bei der nachfolgenden Meßwert-Subtraktion wieder vollständig eliminiert werden.

Vorzugsweise wird erst die vierte auf ein die Zeit/Amplituden-Wandlerschaltung startendes Einzelsignal folgende steigende (oder fallende) Flanke des Zeitbasissignals als Stopp-Signal für die Zeit/Amplituden-Wandlerschaltung verwendet. Da jedes Einzelsignal erst nach der durch die steuerbare Verzögerungsanordnung erzeugten Verzögerung nicht nur der Zeit/Amplituden-Wandlerschaltung sondern auch der Flankenfreigabeschaltung zugeführt wird, die die « Abzählung » der entsprechenden Flanken des Zeitbasissignals durchführt, und erst die jeweils vierte Flanke an die Zeit/Amplituden-Wandlerschaltung weitergibt, bleibt diese Relation immer aufrechterhalten und die Zeit/Amplituden-Wandlerschaltung arbeitet bei allen Zeitabstandsmessungen für einen Zeitraum, dessen Länge wenigstens drei und maximal etwas mehr als vier Periodenlängen des Zeitbasissignals entspricht. Demgemäß wird auch der geeichte Bereich der Kennlinie der Zeit/Amplituden-Wandlerschaltung so gewählt, daß seine zeitliche Länge gleich einer Periodenlänge des Zeitbasissignals ist, und daß er in etwa zwischen den Punkten der Kennlinie liegt, die einem Arbeitszeitraum der Zeit/Amplituden-Wandlerschaltung zwischen drei und vier Periodenlängen entsprechen.

Vorzugsweise ist der geeichte Kennlinienbereich jedoch gegen diese beiden Punkte geringfügig in Richtung längerer Arbeitszeiten verschoben, was mit Hilfe eines Verzögerungsgliedes geschieht, das zwischen den Stoppsignalausgang der zweiten Flankenfreigabeschaltung, die der die beiden Arten von Eichmessungen steuernden Start-Stopp-Steuerung nachgeschaltet ist, und den Stoppeingang der Zeit/Amplituden-Wandlerschaltung geschaltet ist. Der Wert der von diesem Verzögerungsglied gelieferten Verzögerung wird so bemessen, daß er gleich der Ansprechverzögerung der Eingangsstufe der ersten Flankenfreigabeschaltung ist. Dies hat folgenden Zweck : Jedes Einzelsignal wird gleichzeitig an die Zeit/Amplituden-Wandlerschaltung und an die erste Flankenfreigabeschaltung gelegt. Während die Zeit/Amplituden-Wandlerschaltung daraufhin in jedem Fall sofort mit dem Meßbetrieb beginnt, kann es dann, wenn das Einzelsignal sehr knapp vor der nächsten steigenden (oder fallenden) Flanke des Zeitbasissignals liegt, geschehen, daß die erste Flankenfreigabeschaltung wegen der Ansprechverzögerung ihrer Eingangsstufe diese Flanke nicht mehr erfaßt und somit erst die fünfte steigende (oder fallende) Flanke des Zeitbasissignals als Stopp-Signal für die Zeit/Amplituden-Wandlerschaltung freigibt. Da in diesen Fällen die Zeit/Amplituden-Wandlerschaltung etwas länger als vier Periodenlängen des Zeitbasissignals arbeitet, könnte hier ohne die oben erwähnte Verschiebung des geeichten Kennlinienbereiches nach « hinten », d. h. zu den längeren Zeiten hin, der Meßwert nach hinten aus dem geeichten Bereich herausfallen und somit die Genauigkeit des End-Meßergebnisses verschlechtern.

Mit großem Vorteil läßt sich das erfindungsgemäße Verfahren auch überall dort einsetzen, wo in die angestrebte Meßwertbildung die Differenz der Laufzeiten eingeht, die die Einzelsignale einer ersten Signalgruppe bzw. die Einzelsignale einer zweiten Signalgruppe von ihrer Erzeugung bis zur Eingabe in die Zeitmeßschaltung benötigen.

In solchen Fällen ist es nach dem ein völlig frei laufendes Zeitbasissignal benutzenden Stand der Technik erforderlich, für jedes der Einzelsignale eine vollständige dreiteilige Zeitmessung durchzuführen, d. h. mit einer Zeit/Amplituden-Wandlerschaltung als ersten Feinmeßwert den Zeitabstand zu messen, den ein für den Erzeugungszeitpunkt des jeweiligen Einzelsignals signifikantes Auslösesignal von einer definierten Flanke des Zeitbasissignals aufweist, als zweiten Feinmeßwert ebenfalls mit derselben Zeit/Amplituden-Wandlerschaltung den Zeitabstand zu messen, den das jeweilige nach Beendigung seiner Laufzeit in die Zeitmeßschaltung eingespeiste Einzelsignal von einer definierten Flanke des Zeitbasissignals besitzt und als Grobmeßwert die Perioden des Zeitbasissignals abzuzählen, die zwischen den beiden eben genannten Flanken liegen. Aus diesen drei Meßwerten kann dann die Laufzeit des Einzelsignals berechnet werden, so daß also nach dem Stand der Technik zur Ermittlung der Laufzeitdifferenz zweier solcher Einzelsignale vier Feinmeßwert- und zwei Grobmeßwertbildungen erforderlich sind.

Neben dem erhöhten meßtechnischen Aufwand ergibt sich dabei der gravierende Nachteil, daß die Zeit/Amplituden-Wandlerschaltung und der gesamte Meßkanal nicht mit konstanter Frequenz betrieben werden können, weil die auszumessenden Laufzeiten das interessierende Meßergebnis enthalten und damit veränderlich sind und die Zeit/Amplituden-Wandlerschaltung bei einer dreiteiligen Zeitmessung im allgemeinen in kürzeren Zeitabständen betrieben wird als von einer dreiteiligen Zeitmessung zur nächsten. Dieser aperiodische Betrieb des Meßkanals hat aber, wie bereits erwähnt, eine Verschlechterung der Genauigkeit der so erzielten Meßergebnisse zur Folge.

Das erfindungsgemäße Verfahren bietet demgegenüber in einer Weiterbildung die Möglichkeit, solche Laufzeitdifferenzen so zu bestimmen, wie dies in Anspruch 19 niedergelegt ist.

Dadurch, daß das Auslösesignal für jedes Einzelsignal gemäß Anspruch 1 ohnehin mit dem Zeitbasissignal phasenstarr korreliert ist, genügt es, unter Wegfall der oben beschriebenen jeweiligen ersten Feinmeßwertbildung nur die Grobmeßwerte für wenigstens ein Einzelsignal der einen Signalgruppe und ein Einzelsignal der anderen Signalgruppe und gemäß Anspruch 1 die Feinmeßwerte aller Einzelsignale beider Signalgruppen zu ermitteln, um hieraus die gesuchte Laufzeitdifferenz mit der Genauigkeit, mit der die Periode des Zeitbasissignals konstant und bekannt ist, zu erhalten. Durch den Wegfall der « vorderen » Feinmeßwertbildungen ist es möglich, durch eine entsprechende Wahl der Zeitpunkte, in denen die Auslösesignale erzeugt werden, die Einzelsignale am Eingang der Zeitmeßschaltung auch dann in strenger Periodizität zu erhalten wenn die Einzelsignale der verschiedenen Signalgruppen sehr unterschiedliche Laufzeiten aufweisen und alternierend erzeugt werden.

Es sei darauf hingewiesen, daß die Verzögerung, die zwischen dem jeweiligen Erzeugungszeitpunkt der wenigstens zwei Einzelsignale, für die ein Grobmeßwert ermittelt wird, und der nachfolgenden (oder vorausgehenden) Flanke des Zeitbasissignals liegt, mit der die Periodenzählung begonnen wird, ohne Einfluß auf das Meßergebnis ist, da sie in dem kurzen Zeitraum, innerhalb dessen diese Einzelsignale erzeugt werden können, mit Sicherheit als kontant betrachtet werden kann und sich somit bei der nachfolgenden Differenzbildung heraushebt.

Werden Grobmeßwerte für jedes Einzelsignal einer Signalgruppe gesondert ermittelt, so kann es aufgrund der systematisch fortschreitenden Verzögerung der zu einer Signalgruppe gehörenden Einzelsignale geschehen, daß eines oder mehrere dieser Signale die Zeit/Amplituden-Wandlerschaltung zu einem Zeitpunkt starten, der nach dem Auftreten derjenigen Flanke des Zeitbasissignals liegt, die ohne die Verzögerung als nächste auf das betreffende Einzelsignal gefolgt wäre. Der Grobmeßwert hat dann einen um 1 höheren Zählwert, der aber durch die Differenzbildung mit dem zugehörigen entsprechend größeren Feinmeßwert der Zeit/Amplituden-Wandlerschaltung wieder korrigiert wird.

Um die im Rahmen des erfindungsgemäßen Verfahrens erhaltenen, die Einzelmeßwerte verkörpernden Ausgangsspannungen der Zeit/Amplituden-Wandlerschaltung beim Übertrag in die nachfolgende Schaltungseinheit, beispielsweise eine als Analog-Zwischenspeicher dienende Sample-and-Hold-Schaltung nicht mit später nicht mehr korrigierbaren Fehlern zu belasten, wird dieser Übertrag vorzugsweise so gesteuert, daß er bzw. sein die momentane Ausgangsspannung der Zeit/Amplituden-Wandlerschaltung in der Sample-and-Hold-Schaltung festhaltendes Endsignal mit dem Zeitbasissignal synchronisiert ist. Es hat sich nämlich gezeigt, daß bei einer Zeitmeßschaltung der hier in Rede stehenden Art das Zeitbasissignal überall und damit auch auf der den Ausgang der Zeit/Amplituden-Wandlerschaltung mit dem Eingang der Sample-and-Hold-Schaltung verbindenden Leitung zwar als sehr kleines aber der Ausgangsspannung der Zeit/Amplituden-Wandlerschaltung doch einen merklichen Fehler aufprägendes Störsignal vorhanden ist. Der Amplitudenverlauf dieses Störsignals ist aber exakt mit dem Zeitbasissignal synchronisiert, so daß sich durch die synchrone Steuerung des Übertrags der analogen Meßspannung von der Zeit/Amplituden-Wandlerschaltung auf die Sample-and-Hold-Schaltung ein immer gleich großer Fehleranteil ergibt, der bei der späteren Subtraktion der Meßwerte wieder herausfällt.

Die Erfindung wird im folgenden anhand eines Ausführungsbeispiels unter Bezugnahme auf die Zeichnung beschrieben ; in dieser zeigt :

Figur 1 eine schematische Gesamtdarstellung einer erfindungsgemäßen Zeitmeßvorrichtung,

Figur 2 ein Ausführungsbeispiel für eine steuerbare Verzögerungsanordnung gemäß Fig. 1,

Figur 3 weitere Einzelheiten von Schaltungsanordnungen aus Fig. 1,

Figur 4 ein erläuterndes Signaldiagramm und

Figur 5 ein Ausführungsbeispiel für eine Zwischenspeicher-Steuerung gemäß der Erfindung.

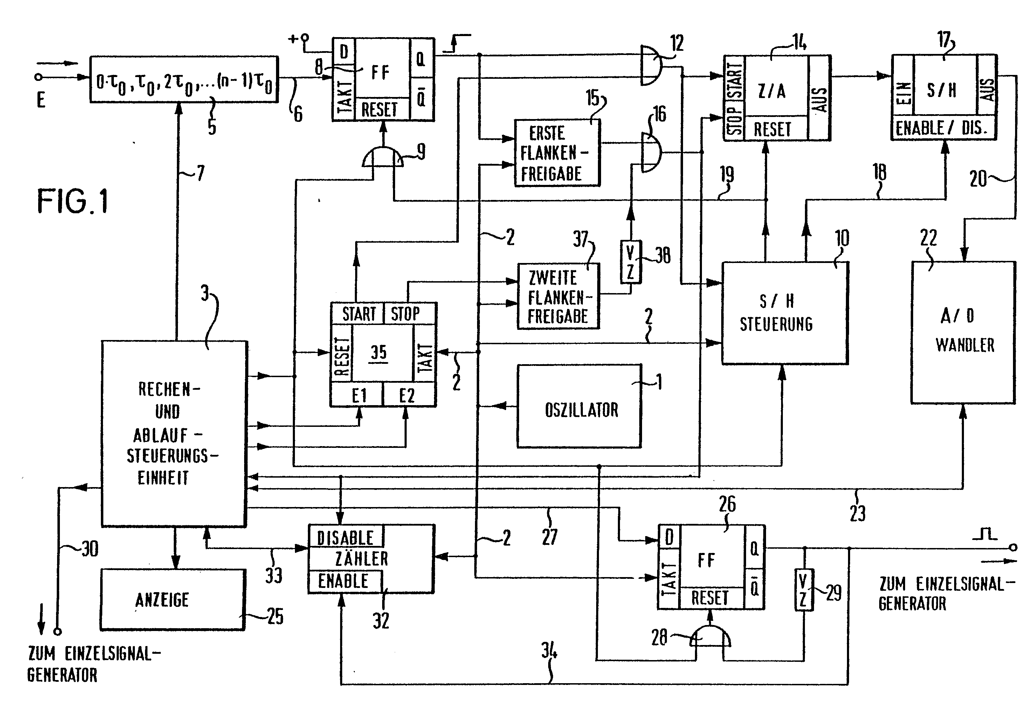

Wie man der Fig. 1 entnimmt, weist eine erfindungsgemäße Zeitmeßvorrichtung einen quarzgesteuerten Oszillator 1 auf, der das Zeitbasissignal mit einer Frequenz von beispielsweise 15 MHz liefert. Dieses Zeitbasissignal wird über die Leitungen 2 all denjenigen Schaltungsteilen zugeführt, die in irgendeiner Weise mit dem Zeitbasissignal synchronisierte Signale erzeugen oder weitergeben sollen. Die gesamte Schaltungsanordnung wird von einer zentralen Rechen- und Ablaufsteuerungs-Einheit 3 gemäß den Erfordernissen der jeweiligen Meßaufgabe gesteuert, in deren Rahmen die Zeitmeßvorrichtung zur Verwendung kommt.

Die Einzelsignale, deren Zeitabstände zu einer nachfolgenden, definierten steigengen Flanke des Zeitbasissignals gemessen werden sollen, werden in die Zeitmeßvorrichtung gemäß Fig. 1 über den Eingang E eingespeist. Von dort gelangen sie unmittelbar zu einer steuerbaren Verzögerungsanordnung 5, auf deren Ausgangsleitung 6 diese Einzelsignale in Abhängigkeit von einem von der Rechen- und Ablaufsteuerungseinheit 3 über die Leitung 7 an die steuerbare Verzögerungsanordnung 5 abgegebenen Signal mit einer Verzögerung $0 \cdot \tau_0$, d. h. unverzögert oder mit einer Verzögerung erscheinen, die ein ganzzahliges Vielfaches der Einheitsverzögerung $\tau_0$ ist.

Ein so verzögertes Einzelsignal gelangt über die Leitung 6 an den Takteingang eines Flip-Flops 8, das zuvor über das ODER-Gatter 9 entweder mit Hilfe eines von der Rechen- und Ablaufsteuerungs-Einheit 3 abgegebenen Master-Rücksetzimpulses oder mit Hilfe eines von einer Zwischenspeicher-Steuerung 10 abgegebenen Rücksetzimpulses in den rückgesetzten Zustand gebracht worden ist.

Da der Dateneingang des D-Flip-Flops 8 ständig auf einer positiven Spannung, d. h. auf einer logischen 1 liegt, wird mit der steigenden Flanke des auf der Leitung 6 zugeführten Einzelsignals der zuvor auf logisch 0 liegende Q-Ausgang des Flip-Flops 8 auf logisch 1 gesetzt.

Die dabei entstehende ansteigende Flanke gelangt einerseits über das ODER-Gatter 12 an den Start-Eingang einer Zeit/Amplituden-Wandlerschaltung 14, die daraufhin mit dem Meßvorgang beginnt, und an einen Triggereingang der Zwischenspeicher-Steuerung 10, sowie andererseits an den Triggereingang einer ersten Flankenfreigabe-Schaltung 15, die an ihrem zweiten Eingang über die Leitung 2 das Zeitbasissignal erhält und nach Triggerung durch das Q-Ausgangssignal des Flip-Flops 8 die steigenden Flanken des Zeitbasissignals abzählt und die jeweils vierte Flanke über das ODER-Gatter 16 an den Stopp-Eingang der Zeit/Amplituden-Wandlerschaltung 14 liefert, die hierdurch ihren Meßbetrieb einstellt und die erreichte Ausgangsspannung solange beibehält, bis diese unter der Regie der Zwischenspeicher-Steuerung 10 in eine als Analog-Zwischenspeicher dienende Sample-and-Hold-Schaltung 17 übernommen ist. Zu diesem Zweck wird die Sample-and-Hold-Schaltung 17 von der Steuerung 10 über die Leitung 18 mit einem entsprechenden Steuersignal versorgt.

Ist diese Signalübernahme beendet, so gibt die Zwischenspeicher-Steuerung 10 über die Leitung 19 ein Rücksetzsignal ab, durch das die Zeit/Amplituden-Wandlerschaltung 14 und, wie oben bereits erwähnt, das D-Flip-Flop 8 in ihren jeweiligen Ausgangszustand zurückgesetzt werden, in dem sie für die Verarbeitung des nächsten über den Eingang E hereinkommenden Einzelsignals bereit sind.

Das am Ausgang der Sample-and-Hold-Schaltung 17 anstehende analoge Meßergebnis gelangt über die Leitung 20 an einen Analog/Digital-Wandler 22, der es unter der Regie der Rechen- und Ablauf-Steuerungseinheit 3 in eine digitale Form umsetzt und diesen Digitalwert an die Rechen- und Ablauf-Steuerungseinheit 3 zur weiteren Verarbeitung über die bidirektionalen Leitungen 23 abgibt, auf denen er auch seine Steuerbefehle empfängt. Die Rechen- und Ablauf-Steuerungseinheit 3 verarbeitet die so erhaltenen Meßergebnisse und die auf ähnliche Weise gewonnenen Eich-Meßwerte in der erforderlichen Weise und berechnet das eigentlich interessierende Meßergebnis, das über eine Anzeigeeinheit 25 dargestellt werden kann.

Im rechten unteren Bereich der Fig. 1 ist ein D-Flip-Flop 26 dargestellt, dessen D-Eingang über eine Leitung 27 von der zentralen Rechen- und Ablauf-Steuerungseinheit 3 zugegebenen Zeitpunkten mit einer logischen 1 versorgt werden kann.

Dieses D-Flip-Flop 26 stellt die einfachste Form einer Synchronisationsschaltung dar, die erfindungsgemäß vorgesehen ist, um immer dann, wenn über die Leitung 27 ein entsprechendes Vorbereitungssignal von der Rechen- und Ablauf-Steuerungseinheit 3 abgegeben worden ist, ein zum Zeitbasissignal eine exakt definierte Phasenlage besitzendes Triggersignal für einen in der Fig. 1 nicht dargestellten Generator abzugeben, der somit die später am Eingang E erscheinenden Einzelsignale in einer streng phasenstarren Korrelation zum Zeitbasissignal erzeugt. Zu diesem Zweck wird dem Takteingang des D-Flip-Flops 26 über die entsprechende Leitung 2 das Zeitbasissignal des Oszillators 1 zugeführt. Dies hat zur Folge, daß das zuvor über das ODER-Gatter 28 entweder mit Hilfe des von der Rechen- und Ablauf-Steuerungseinheit 3 erzeugten Master-Rücksetzsignals oder mit Hilfe des an seinem eigenen Q-Ausgang erscheinenden und über das Verzögerungsglied 29 zur Erzielung einer gewissen Mindestimpulsbreite verzögerten Triggersignals zurückgesetzte D-Flip-Flop 26 durch die erste auf das über die Leitung 27 zugeführte Vorbereitungssignal folgende steigende Flanke des Zeitbasissignals gesetzt wird, so daß an seinem Q-Ausgang das gewünschte Triggersignal für den Einzelsignalgenerator in zeitlicher Korrelation zum Zeitbasissignal erscheint.

Die zur Auslösung jeweils eines synchronisierten Triggersignals von der Rechen- und Ablauf-Steuerungseinheit 3 abgegebenen Vorbereitungssignale werden mit den erforderlichen Zeitabständen so erzeugt, daß der Einzelsignalgenerator zunächst n, d. h. beispielsweise acht Einzelsignale der ersten und dann n, d. h. wiederum acht Einzelsignale der zweiten Art erzeugt. Die hierfür erforderliche Information kann ihm wieder von der Rechen- und Ablauf-Steuerungseinheit 3 zugeführt werden, wie dies durch die Leitung 30 angedeutet ist.

Es wird davon ausgegangen, daß jedes dieser Einzelsignale auf dem Weg vom Signalgenerator bis zum Eingang E der Zeitmeßschaltung einer bestimmten Verzögerung unterliegt, deren Größe unbekannt, für die Einzelsignale einer Signalgruppe gleich und von Signalgruppe zu Signalgruppe im allgemeinen verschieden ist.

Sollen nicht nur die Zeitabstände der verzögerten Einzelsignale zu einer definierten nachfolgenden Flanke des Zeitbasissignals, sondern auch wesentlich größere Zeitabstände der Einzelsignale zu irgendwelchen anderen definierten Ereignissen gemessen werden, so können die entsprechenden Meßwerte mit Hilfe eines Zählers 32 gewonnen werden, der über die Leitung 2 das Zeitbasissignal des Oszillators 1 erhält und dessen relevante (d. h. entweder die steigenden oder die fallenden) Flanken abzählt. Der Zählbeginn des Zählers 32 wird vom Synchronisations-Flip-Flop 26 über die Leitung 34 ausgelöst. Das Zählergebnis kann über die bidirektionalen Leitungen 33 vom Zähler 32 in die Rechen- und Ablauf-Steuerungseinheit 3 übertragen werden kann. Der Zählbetrieb des Zählers 32 für jedes Einzelsignal wird durch das Ausgangssignal des ODER-Gatters 16 beendet, das ja auch die Zeit/Amplituden-Wandlerschaltung anhält. Außerdem wird dieses Ausgangssignal des ODER-Gatters 16 der Rechen- und Ablauf-Steuerungseinheit 3 zugeführt, um dieser anzuzeigen, daß nun das Zählergebnis vom Zähler 32 auf den Leitungen 33 übernommen werden kann.

Damit die Zeit/Amplituden-Wandlerschaltung 14 mit Hilfe des Zeitbasissignals immer wieder nachgeeicht werden kann, ist eine Start-Stopp-Steuerung 35 vorgesehen, die je nachdem, ob sie von der Rechen- und Ablauf-Steuerungseinheit 3 an ihren Eingang E1 oder an ihren Eingang E2 ein Triggersignal erhält, zwei verschiedene Eichmessungen durchführen kann.

Bei Ansteuerung des Eingangs E1 liefert sie an ihrem Start- und ihrem Stopp-Ausgang genau gleichzeitig zwei mit dem über die Leitung 2 dem Takteingang der Start-Stopp-Steuerung 35 zugeführten Zeitbasissignal synchronisierte Signale, von denen das eine über das ODER-Gatter 12 dem Starteingang der Zeit/Amplituden-Wandlerschaltung 14 zugeführt wird, die daraufhin zu arbeiten beginnt, während das andere an den Triggereingang einer zweiten Flanken-Freigabe-Schaltung 37 gelegt wird, die an ihrem Takteingang ebenfalls das Zeitbasissignal des Oszillators 1 erhält. Diese zweite Flanken-Freigabe-Schaltung 37 zählt daraufhin die folgenden relevanten, z. B. die steigenden Flanken des Zeitbasissignals ab und gibt die dritte dieser Flanken über ein Verzögerungsglied 38 an das ODER-Gatter 16 weiter, von wo sie als Stopp-Signal an die Zeit/Amplituden-Schaltung 14, den Zähler 32 und die Rechen- und Ablauf-Steuerungseinheit 3 gelangt. Aufgrund dieser Triggerung über den Eingang E1 der Start-Stopp-Steuerung 35 arbeitet also die Zeit/Amplituden-Wandlerschaltung 14 für einen Zeitraum, der etwas länger als drei Perioden des Zeitbasissignals ist und liefert somit einen ersten zur Festlegung einer Eichgeraden geeigneten Meßwert, da ja die Periodenlänge des von dem quarzgesteuerten Oszillator 1 gelieferten Zeitbasissignals mit sehr großer Genauigkeit bekannt und konstant ist.

Legt die Rechen- und Ablauf-Steuerungseinheit 3 ein Triggersignal an den Eingang E2 der Start-Stopp-Steuerung 35, so erzeugt diese wieder an ihren beiden Ausgängen ein Start- und ein Stopp-Signal, die aber diesmal zeitlich um genau eine Periodenlänge des Zeitbasissignals gegeneinander versetzt sind. Sie werden in der gleichen Weise wie oben beschrieben der Zeit/Amplituden-Wandlerschaltung 14 zugeführt, die bei dieser zweiten Art von Eichmessung für einen Zeitraum arbeitet, der etwas länger als vier Periodenlängen des Zeitbasissignals ist. Damit erhält man dann einen zweiten sehr exakten Eichwert, der zusammen mit dem zuvor beschriebenen Eichwert zur Definition einer Eichgeraden geeignet ist, mit deren Hilfe der tatsächliche Kennlinienverlauf der Zeit/Amplituden-Wandlerschaltung angenähert werden kann, wobei sich die tatsächliche Kennlinie und die Eichgerade in den beiden den geeichten Bereich der Kennlinie aufspannenden Meßpunkten schneiden.

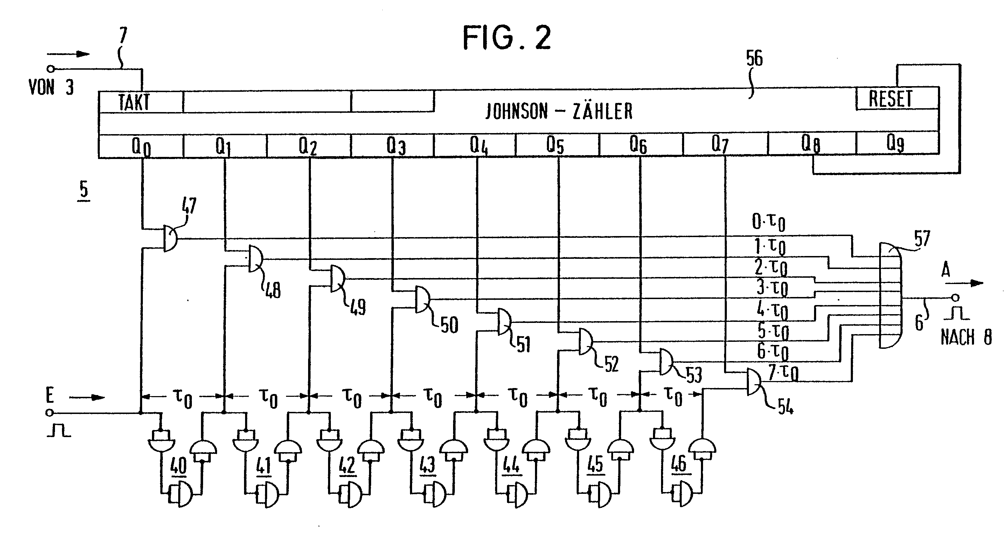

Wegen der Nichtlinearität der tatsächlichen Kennlinie der Zeit/Amplituden-Wandlerschaltung 14 können allerdings auch in dem geeichten Bereich beträchtliche Abweichungen zwischen der Eichgeraden und der tatsächlichen Kennlinie auftreten. Zur Beseitigung der hierdurch möglichen Fehler wird bei dem erfindungsgemäßen Verfahren eine steuerbare Verzögerungsanordnung 5 verwendet, von der ein Ausführungsbeispiel in Fig. 2 genauer wiedergegeben ist. Wie man dieser Figur entnimmt, werden die am Eingang E erscheinenden Einzelsignale einer Kette von sieben hintereinandergeschalteten Verzögerungsgliedern 40 bis 46 zugeführt, von denen jedes aus drei hintereinandergeschalteten UND-Gattern besteht, deren beide Eingänge miteinander kurzgeschlossen sind. Welche Art und welche Anzahl von Verzögerungselementen zur Bildung der Verzögerungsglieder 40 bis 46 gewählt wird, ist von untergeordneter Bedeutung. Wesentlich ist lediglich, daß jedes der Verzögerungsglieder 40 bis 46 in etwa dieselbe Verzögerung $\tau_0$ liefert, wobei allerdings Abweichungen von ± 30 % durchaus tolerierbar sind, und daß das Achtfache dieser Verzögerung $\tau_0$ gleich der zeitlichen Länge des geeichten Kennlinienbereichs der Zeit/Amplituden-Wandlerschaltung 14, d. h. im vorliegenden Fall also in etwa gleich einer Periodenlänge des Zeitbasissignals ist.

Weiterhin umfaßt die steuerbare Verzögerungsanordung 5 acht UND-Gatter 47 bis 54, von denen das erste 47 mit seinem einen Eingang an den Eingang des ersten Verzögerungsgliedes 40, das zweite 48 an den Eingang des zweiten Verzögerungsgliedes 41 usw. angeschlossen ist, während der eine Eingang des letzten UND-Gatters 54 mit dem Ausgang des letzten Verzögerungsgliedes 46 verbunden ist. Die jeweils zweiten Eingänge der UND-Gatter 47 bis 54 sind mit den Ausgängen $Q_0$ bis $Q_7$ eines Johnson-Zählers 56 verbunden, der immer nur an einem seiner Q-Ausgänge eine logische 1 abgibt, während alle anderen Q-Ausgänge auf logisch 0 liegen. Der Takteingang des Johnson-Zählers 56 ist über die Leitung 7 mit der zentralen Rechen- und Ablauf-Steuerungseinheit 3 verbunden, so daß letztere durch die Abgabe einer entsprechenden Anzahl von Taktsignalen festlegen kann, welcher der Q-Ausgänge des Johnson-Zählers 56 eine logische 1 an das zugehörige UND-Gatter legt. Damit wird erreicht, daß immer nur eines der UND-Gatter 47 bis 54 geöffnet ist, während alle anderen gesperrt sind.

Erhält beispielsweise das UND-Gatter 47 vom Ausgang $Q_0$ des Johnson-Zählers 56 eine logische 1, so gelangt ein am Eingang E erscheinendes Einzelsignal der einen Signalgruppe unmittelbar und praktisch unverzögert über den Ausgang dieses UND-Gatters 47 an den zugehörigen Eingang des das gemeinsame Ausgangsglied der steuerbaren Verzögerungsanordnung bildenden ODER-Gatters 57, von wo es an das D-Flip-Flop 8 abgegeben wird. Gleichzeitig durchläuft dieses Einzelsignal natürlich auch alle Verzögerungsglieder 40 bis 46, doch kann es von deren Ausgängen nicht weitergelangen, da die übrigen UND-Gatter 48 bis 54 durch die logischen 0-Pegel gesperrt sind, die bei diesem Schaltzustand von den Ausgängen $Q_1$ bis $Q_7$ des Johnson-Zählers 56 abgegeben werden.

Wird dann beispielsweise von der zentralen Rechen- und Ablaufsteuerungseinheit 3 die Erzeugung eines Einzelsignals der anderen Signalgruppe ausgelöst, so kann bei gleichbleibender Stellung des Johnson-Zählers 56 dieses Einzelsignal in der steuerbaren Verzögerungsanordnung 5 denselben Signalweg durchlaufen wie das unmittelbar vorausgegangene Einzelsignal der anderen Signalgruppe.

Bevor dann das nächste Einzelsignal der ersten Signalgruppe aufgrund eines von der Synchronisationsschaltung 26 an den Einzelsignalgenerator abgegebenen Triggersignals erzeugt wird, gibt die zentrale Rechen- und Ablauf-Steuerungseinheit 3 über die Leitung 7 einen Taktimpuls an den Johnson-Zähler 56, der daraufhin an seinem $Q_1$-Ausgang eine logische 1 abgibt, während alle anderen Q-Ausgänge auf logisch 0 liegen. Erscheint dann das Einzelsignal am Eingang E, so kann es nicht über den Ausgang des nunmehr gesperrten UND-Gatters 47 an das ODER-Gatter 57 gelangen. Vielmehr muß es das erste Verzögerungsglied 40 durchlaufen, worauf es vom nunmehr offenen UND-Gatter 48 an das ODER-Gatter 57 und von dort an das D-Flip-Flop 8 weitergeleitet wird. Somit ist also dieses Einzelsignal durch die steuerbare Verzögerungsanordnung 5 um eine Zeit $\tau_0$ verzögert worden.

Gleiches gilt dann auch für das zweite Einzelsignal der anderen Signalgruppe.

Durch entsprechendes Weitertakten des Johnson-Zählers 56 kann dann jedes nachfolgende Einzelsignalpaar einer Verzögerung unterworfen werden, die jeweils um $\tau_0$ größer ist als die Verzögerung des vorausgegangenen Einzelsignals. Der auf diese Weise maximal erreichbare Verzögerungswert ist $7 \cdot \tau_0$, der dann erreicht wird, wenn der Johnson-Zähler an seinem Ausgang $Q_7$ eine logische 1 aufweist.

Mit Hilfe dieser steuerbaren Verzögerungsanordnung 5 können also jeweils acht Einzelsignale umfassende, ineinander verschachtelte Signalgruppen erzeugt werden. Ist das letzte dieser Signale durchgelaufen, wird der Johnson-Zähler 56 durch ein weiteres auf der Leitung 7 erscheinendes Taktsignal weitergetaktet, so daß an seinem Ausgang $Q_8$ eine logische 1 erscheint, durch die er sich selbst in seinen Ausgangszustand zurücksetzt, in welchem am Ausgang $Q_0$ eine logische 1 zur Verfügung steht.

Damit ist der Johnson-Zähler 56 für die nächste Signalgruppe bereit.

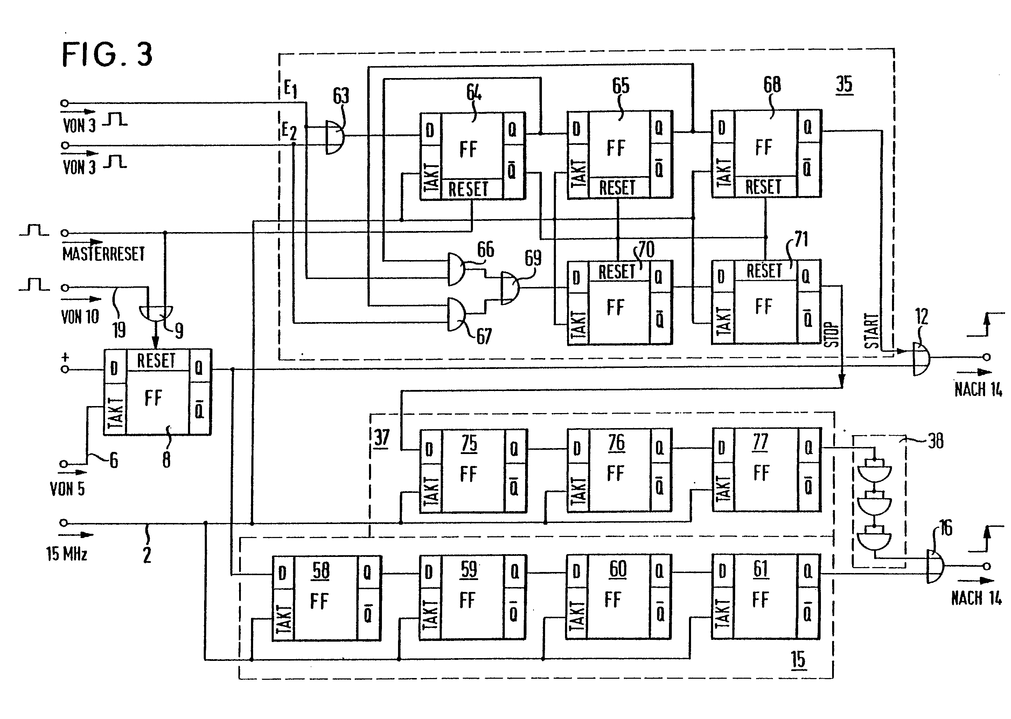

In Fig. 3 sind mehr im Detail die erste und zweite Flanken-Freigabe-Schaltung 15 und 37, die die Eich-Start-Stopp-Signale liefernde Start-Stopp-Steuerung 35 und das der zweiten Flankenfreigabe-Schaltung 37 nachgeschaltete Verzögerungsglied 38 dargestellt.

In Fig. 3 ganz links ist das D-Flip-Flop 8 wiedergegeben, das auf der Leitung 6 die Einzelsignale erhält, nachdem diese die steuerbare Verzögerungsanordnung 5 durchlaufen haben. Trifft ein solches Einzelsignal am Takteingang des D-Flip-Flops 8 ein, so wird dieses durch die steigende Flanke des Einzelsignals gesetzt, wodurch an seinem Q-Ausgang eine logische 1 erscheint, die, wie bereits erwähnt, über das ODER-Gatter 12 als Startsignal an die Zeit/Amplituden-Wandlerschaltung weitergegeben wird. Gleichzeitig wird diese logische 1 dem Dateneingang eines D-Flip-Flops 58 zugeführt, das die Eingangsstufe einer ersten Flanken-Freigabe-Schaltung 15 bildet, die aus einer insgesamt vier D-Flip-Flops 58 bis 61 umfassenden Flip-Flop-Kette besteht, wobei jeweils der Q-Ausgang eines vorausgehenden Flip-Flops mit dem D-Eingang eines nachfolgenden Flip-Flops verbunden ist. Die Takteingänge aller dieser Flip-Flops 58 bis 61 werden über die Leitung 2 mit dem 15-MHz-Zeitbasissignal versorgt. Solange das D-Flip-Flop 8 zurückgesetzt war, waren sämtliche Ketten-Flip-Flops 58 bis 61 mit der in diesem Zustand am Q-Ausgang des D-Flip-Flops 8 vorhandenen logischen 0 vollgeschoben, so daß auch am Q-Ausgang des letzten Ketten-Flip-Flops 61 eine logische 0 vorhanden war, die an das ODER-Gatter 16 weitergegeben wurde. Da im Normalfall auch am anderen Eingang des ODER-Gatters 16 eine logische 0 anliegt, liegt also zum betrachteten Zeitpunkt auch der Ausgang dieses ODER-Gatters auf logisch 0, so daß die Zeit/Amplituden-Wandlerschaltung 14 kein Stopp-Signal erhält.

Schaltet nun der Q-Ausgang des D-Flip-Flops 8 aufgrund des Eintreffens eines Einzelsignals auf logisch 1, so wird diese logische 1 mit den nächsten vier steigenden Flanken des Zeitbasissignals durch die Flip-Flop-Kette 58 bis 61 hindurchgeschoben, d. h. sie erscheint gleichzeitig mit der vierten steigenden Flanke am Q-Ausgang des Flip-Flops 61 und gelangt über das ODER-Gatter 16 als Stopp-Signal an die Zeit/Amplituden-Wandlerschaltung 14.

Allerdings besitzt das die Eingangsstufe dieser ersten Flanken-Freigabe-Schaltung 15 bildende D-Flip-Flop 58 eine gewisse Ansprechverzögerung, d. h. es muß ein gewisser Mindestzeitraum zwischen dem Anlegen der logischen 1 an den D-Eingang dieses Flip-Flops und dem Erscheinen der nächsten Taktsignalflanke vergehen, damit durch diese Flanke die logische 1 auch wirklich an den Q-Ausgang übernommen wird. Nun sind zwar die das D-Flip-Flop 8 triggernden Einzelsignale so erzeugt worden, daß sie eine feste zeitliche Korrelation zum Zeitbasissignal besitzen. Zwischen ihrer Erzeugung und ihrem Eintreten in die Zeitmeßvorrichtung erleiden sie jedoch eine Verzögerung unbekannter Größe, die durch das erfindungsgemäße Zeitmeßverfahren ausgemessen werden soll. Diese unbekannte Verzögerung kann ohne weiteres einen solchen Wert annehmen, daß entweder das unverzögert durch die Verzögerungsanordnung 5 hindurchgehende oder eines der zusätzlich verzögerten Einzelsignale das D-Flip-Flop 8 so kurz vor dem Auftreten der nächsten steigenden Flanke des Zeitbasissignals triggert, daß das Flip-Flop 58 aufgrund seiner oben geschilderten Ansprechverzögerung auf diese steigende Flanke nicht mehr reagiert, so daß das Flip-Flop 61 erst beim Auftreten der fünften Siganlflanke ein Stopp-Signal an die Zeit/Amplituden-Wandlerschaltung 14 abgibt. In diesem Fall arbeitet dann die Zeit/Amplituden-Wandlerschaltung etwas länger als vier Perioden des Zeitbasissignals.

Im oberen Bereich der Fig. 3 ist im Detail die Start-Stopp-Steuerung 35 wiedergegeben, die von der zentralen Rechen- und Ablauf-Steuerungseinheit 3 entweder an ihrem Eingang E1 oder an ihrem Eingang E2 ein Triggersignal erhält und daraufhin entweder eine Eichmessung erster Art oder eine Eichmessung zweiter Art veranlaßt.

Solange an keinem der beiden Eingänge E1, E2 ein Triggersignal anliegt, d. h. also diese beiden Eingänge auf logisch 0 gehalten werden, gibt auch ein mit diesen beiden Eingängen verbundenes ODER-Gatter 63 an seinem Ausgang eine logische 0 ab, die dem D-Eingang eines Flip-Flops 64 zugeführt wird. Da der Takteingang dieses Flip-Flops 64 mit dem Zeitbasissignal verbunden ist, wird diese logische 0 bei diesem Status der Eingänge E1 und E2 auch am Q-Ausgang des Flip-Flops 64 aufrechterhalten, von wo sie einerseits an den Dateneingang eines weiteren Flip-Flops 65 sowie an den einen Eingang eines UND-Gatters 66 gelegt ist. Der gleichzeitig auf logisch 1 liegende Q̄-Ausgang des Flip-Flops 64 ist mit dem Rücksetz-Eingang des Flip-Flops 65 verbunden, das durch diesen Logikpegel in seinem zurückgesetzten Zustand gehalten wird, so daß an seinem Q-Ausgang ebenfalls eine logische 0 erscheint, die auf den einen Eingang eines weiteren UND-Gatters 67 und den D-Eingang eines dritten Flip-Flops 68 geführt ist, dessen Rücksetz-Eingang ebenfalls mit dem Q̄-Ausgang des Flip-Flops 64 verbunden ist, so daß der Q-Ausgang des Flip-Flops 68, der gleichzeitig der Start-Ausgang der Start-Stopp-Steuerung 35 ist, eine logische 0 aufweist, die an den zweiten Eingang des ODER-Gatters 12 geführt ist. Dadurch, daß die beiden UND-Gatter 66 und 67 in diesem Zustand, in dem noch kein Triggersignal an die Eingänge E1 oder E2 angelegt ist, an beiden Eingängen jeweils eine logische 0 empfangen, geben sie auch an ihrem jeweiligen Ausgang eine logische 0 ab, so daß das ihnen nachgeschaltete ODER-Gatter an seinem Ausgang ebenfalls eine logische 0 zeigt, die dem D-Eingang eines vierten Flip-Flops 70 zugeführt wird, dessen Rücksetz-Eingang ebenfalls mit dem Q̄-Ausgang des Flip-Flops 64 verbunden ist, so daß das Flip-Flop 70 in seinem zurückgesetzten Zustand gehalten wird, in dem an seinem Q-Ausgang eine logische 0 erscheint, die an den D-Eingang eines fünften Flip-Flops 71 weitergegeben wird, dessen Rücksetz-Eingang ebenfalls mit dem Q̄-Ausgang des Flip-Flops 64 verbunden ist, so daß auch dieses Flip-Flop 71 zurückgesetzt ist. Der in diesem Stadium auf logisch 0 liegende Q-Ausgang des Flip-Flops 71 ist der Stopp-Ausgang der Start-Stopp-Steuerung 35. Auch die Takteingänge der Flip-Flops 65, 68, 70 und 71 sind mit der das Zeitbasissignal führenden Leitung 2 verbunden.

Wird nun zur Durchführung eines Eichvorganges der ersten Art von der zentralen Rechen- und Ablauf-Steuerungseinheit 3 ein positives Triggersignal an den Eingang E1 der Start-Stopp-Steuerung 35 gelegt, so gelangt der damit verbundene logische 1-Pegel einerseits über das ODER-Gatter 63 an den D-Eingang des Flip-Flops 64 und andererseits an den einen der beiden Eingänge des UND-Gatters 66. Dieser logische 1-Pegel wird durch die zentrale Rechen- und Ablauf-Steuerungseinheit 3 für einen längeren Zeitraum aufrechterhalten. Dadurch kann zunächst durch die erste auf das Anlegen des Triggersignals folgende ansteigende Flanke des Zeitbasissignals die am Dateneingang des Flip-Flops 64 anliegende logische 1 auf den Q-Ausgang übertragen werden. Von dort gelangt sie einerseits an den Dateneingang des Flip-Flops 65 und andererseits über das nunmehr an seinen beiden Eingängen eine logische 1 aufweisende UND-Gatter 66 und das ODER-Gatter 69 an den Dateneingang des Flip-Flops 70.

Da gleichzeitig mit dem Erscheinen eines logischen 1-Pegels am Q-Ausgang des Flip-Flops 64 der $\bar{Q}$-Ausgang dieses Flip-Flops auf logisch 0 abfällt, werden die mit diesem Ausgang verbundenen Rücksetz-Eingänge der Flip-Flops 65, 68, 70 und 71 freigegeben, so daß diese Flip-Flops im folgenden auf die Signale an ihren Daten- und Takteingängen reagieren können.

Da bei gesetztem Flip-Flop 64 sowohl am Dateneingang des Flip-Flops 65 als auch am Dateneingang des Flip-Flops 70 eine logische 1 anliegt, werden durch die nächstfolgende steigende Flanke des Zeitbasissignals diese beiden Flip-Flops gleichzeitig gesetzt, so daß an ihren Q-Ausgängen eine logische 1 erscheint, die an die Dateneingänge der beiden nachfolgenden Flip-Flops 68 bzw. 71 gelegt wird. Die am Q-Ausgang des Flip-Flops 65 vorhandene logische 1 gelangt überdies an den einen Eingang des UND-Gatters 67, das über seinen anderen auf logisch 0 liegenden Eingang gesperrt ist. Durch die dritte auf das Anlegen des Triggersignals folgende steigende Flanke des Zeitbasissignals werden dann auch die beiden Flip-Flops 68 und 71 gleichzeitig gesetzt, so daß an ihren Q-Ausgängen, die mit dem Start- bzw. Stopp-Ausgang der Start-Stopp-Steuerung 35 identisch sind, gleichzeitig zwei steigende Flanken erscheinen, von denen die eine über das ODER-Gatter 12 als Startsignal an die Zeit/Amplituden-Wandlerschaltung 14 gelangt, während der am Stopp-Ausgang der Start-Stopp-Steuerung 35 erscheinende logische 1-Pegel an den Eingang einer zweiten Flanken-Freigabe-Schaltung 37 gelegt wird, die ähnlich wie die erste Flanken-Freigabe-Schaltung 15 aus einer Kette von D-Flip-Flops 75, 76 und 77 aufgebaut ist, bei denen jeweils der Q-Ausgang eines vorausgehenden Flip-Flops mit dem D-Eingang eines nachfolgenden Flip-Flops verbunden ist und bei der sämtliche Takteingänge mit der das Zeitbasissignal führenden Leitung 2 verbunden sind. Da diese zweite Flanken-Freigabe-Schaltung nur drei Flip-Flops umfaßt, wird durch die dritte nach dem gleichzeitigen Erscheinen des Start- und des Stopp-Signals an den betreffenden Ausgängen der Start-Stopp-Steuerung 35 auftretende steigende Flanke des Zeitbasissignals der Q-Ausgang des letzten Flip-Flops 77 dieser Kette auf logisch 1 gesetzt. Die dabei auftretende steigende Flanke wird durch das diesem Ausgang nachgeschaltete Verzögerungsglied 38, das im vorliegenden Fall aus drei in Reihe geschalteten und mit ihren Eingängen kurzgeschlossenen Gattern besteht, um eine Zeit verzögert, die gleich der Ansprechverzögerung des Eingangs-Flip-Flops 58 der ersten Flankenfreigabe-Schaltung 15 ist, und dann über das ODER-Gatter 16 der Zeit/Amplituden-Wandlerschaltung 14 als Stopp-Signal zugeführt. Somit arbeitet also die Zeit/Amplituden-Wandlerschaltung 14 bei diesem Eichvorgang erster Art für einen Zeitraum, der um die geringfügige Verzögerung des Verzögerungsgliedes 38 länger als drei Periodenlängen des Zeitbasissignals ist.

Ist diese Eichmessung erster Art abgeschlossen, erzeugt die Rechen- und Ablauf-Steuerungseinheit 3 ein Master-Rücksetzsignal, durch das das Flip-Flop 64 wieder zurückgesetzt wird. Da inzwischen auch am Eingang E1 keine logische 1 mehr anliegt, bleibt das Flip-Flop 64 zurückgesetzt. Durch die beim Zurücksetzen an seinem $\bar{Q}$-Ausgang auftretende logische 1 werden auch die übrigen Flip-Flops 65, 68, 70 und 71 zwangsweise zurückgesetzt, so weit dies nicht schon durch ein Weiterschieben von logischen 0-Pegeln geschehen ist. Der Start- und der Stopp-Ausgang der Start-Stopp-Steuerung 35 liegen damit wieder auf logisch 0.

Soll nun eine Eichmessung zweiter Art durchgeführt werden, so liefert die Rechen- und Ablauf-Steuerungseinheit 3 ein entsprechendes Triggersignal an den Eingang E2. Die daraufhin in Abhängigkeit von den steigenden Flanken des Zeitbasissignals ablaufenden Vorgänge entsprechen weitgehend den oben für die Eichmessung erster Art beschriebenen Vorgängen. Der einzige Unterschied besteht darin, daß der Dateneingang des Flip-Flops 70 seine logische 1 nicht gleichzeitig mit dem Dateneingang des Flip-Flops 65, sondern erst gleichzeitig mit dem Dateneingang des Flip-Flops 68 erhält, da im vorliegenden Fall das UND-Gatter 66 über den Eingang E1 gesperrt ist und das über den Eingang E2 geöffnete UND-Gatter 67 mit seinem zweiten Eingang mit dem Q-Ausgang des Flip-Flops 65 verbunden ist. Im Endeffekt hat dies zur Folge, daß das Startsignal für die Zeit/Amplituden-Wandlerschaltung 14 am Q-Ausgang des Flip-Flops 68 um eine Periodenlänge des Zeitbasissignals früher erscheint, als das Stopp-Signal am Q-Ausgang des Flip-Flops 71.

Da dieses Stopp-Signal dann ebenfalls wieder durch die Flanken-Freigabe-Schaltung 37 um drei Periodenlängen verschoben und durch das Verzögerungsglied 38 in der gleichen Weise wie das Stopp-Signal bei der Eichmessung erster Art verzögert wird, arbeitet in diesem Fall die Zeit/Amplituden-Wandlerschaltung für einen Zeitraum, der etwas größer als vier Periodenlängen des Zeitbasissignals ist.

Da, wie oben bereits erwähnt, die Zeit/Amplituden-Wandlerschaltung bei der Durchführung der Zeitabstandsmessungen für die Einzelsignale ebenfalls für einen Zeitraum arbeitet, der wenigstens gleich drei und höchstens gleich etwas mehr als vier Periodenlängen des Zeitbasissignals ist, ist also sichergestellt, daß die dabei gewonnenen Meßwerte immer in den zwischen den beiden Eich-Meßpunkten liegenden, geeichten Kennlinienbereich der Zeit/Amplituden-Wandlerschaltung fallen.

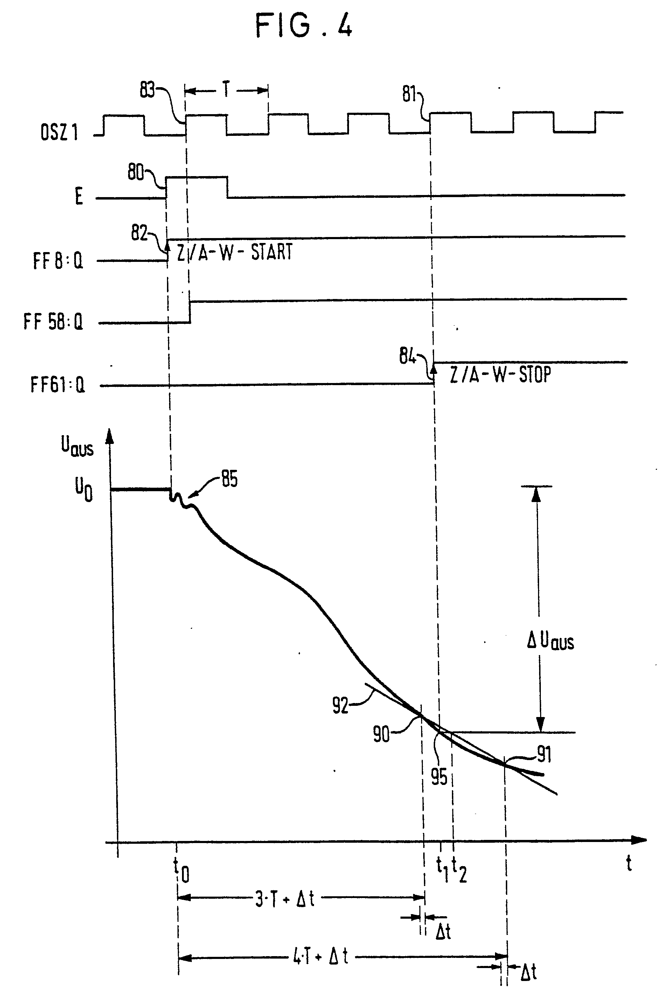

Bevor dies anhand der Fig. 4 näher erläutert wird, sei noch darauf hingewiesen, daß es vorteilhaft ist, jede Zeitabstandsmessung für ein Einzelsignal zwischen zwei Eichmessungen einzuschließen, von denen die eine erster und die andere zweiter Art sein kann. Dabei ist es vorteilhaft, wenn über die zentrale Rechen- und Ablauf-Steuerungseinheit 3 die Auslösung der Einzelsignale einerseits und der Eichmessungen andererseits so gesteuert wird, daß die Zeit/Amplituden-Wandlerschaltung möglichst periodisch betrieben wird.

In Fig. 4 ist in der obersten Zeile das vom Oszillator 1 erzeugte Zeitbasissignal als Rechtecksignal dargestellt, dessen Periodenlänge mit T bezeichnet ist. In der darunterliegenden Zeile ist ein am Eingang E erscheinendes Einzelsignal dargestellt, wobei nicht der gesamte in dieser zweiten Zeile wiedergegebene Impuls, sondern nur dessen steigende Flanke 80 das Einzelsignal darstellt, dessen Zeitabstand zu einer definierten nachfolgenden Flanke, im vorliegenden Fall zur Flanke 81 des Zeitbasissignals gemessen werden soll.

Durch die Flanke 80 wird das Flip-Flop 8 gesetzt, so daß dessen Q-Ausgang, wie in der dritten Zeile von oben der Fig. 4 dargestellt, auf einen logischen 1-Pegel springt. Die dabei auftretende steigende Flanke 82 startet über das ODER-Gatter 12 die Zeit/Amplituden-Wandlerschaltung, während der sich an die Flanke 82 anschließende logische 1-Pegel die Flankenfreigabe-Schaltung 15 für ein Abzählen der nachfolgenden steigenden Flanken des Zeitbasissignals vorbereitet. Dies ist in der vierten Zeile von oben der Fig. 4 mit dem Q-Ausgangssignal des Flip-Flops 58 angedeutet, das beim Auftreten der ersten auf die Einzelsignalflanke 80 folgenden steigenden Flanke 83 des Zeitbasissignals auf logisch 1 geht. Diese logische 1 wird dann durch die Flip-Flop-Kette 59, 60, 61 mit jeder steigenden Flanke des Zeitbasissignals weitergeschoben, so daß beim Auftreten der vierten Flanke 81 des Zeitbasissignals der Q-Ausgang des letzten Flip-Flops 61 dieser Kette auf logisch 1 geht. Die dabei auftretende steigende Flanke 84 wird über das ODER-Gatter 16 der Zeit/Amplituden-Wandlerschaltung als Stopp-Signal zugeführt.

Unter diesen Impulsdiagrammen ist eine typische Ausgangskennlinie einer Zeit/Amplituden-Wandlerschaltung 14 dargestellt. Eine solche Schaltung besteht im wesentlichen aus einem Ladekondensator, der über einen zu ihm parallel liegenden, im Ruhezustand geschlossenen Schalter entladen ist, so daß im Ruhezustand die beiden Kondensatorplatten an der gleichen Spannung und zwar an der Versorgungsspannung $U_0$ der Zeit/Amplituden-Wandler-

schaltung 14 liegen. In Serie zu diesem Ladekondensator liegt eine ein- und wieder ausschaltbare Konstantstromquelle, die aus einem genügend schnell schaltbaren GHz-Transistor und einem entsprechend der gewünschten Größe der Strom-Einprägung ausgelegten Emitter-Widerstand besteht. Es sind also miteinander der Reihe nach verbunden: Versorgungsspannung $U_0$ mit der einen Ladekondensator-Platte, die andere Ladekondensator-Platte mit dem Kollektor des Stromquellentransistors, der Emitter des Stromquellentransistors mit dem Emitterwiderstand und der Emitterwiderstand mit der Signalmasse. Über die Basis des Stromquellentransistors wird diese Konstantstromquelle mittels eines normalen, in der Zeit/Amplituden-Wandlerschaltung 14 erzeugten Logiksignals von dem vom ODER-Gatter 12 kommenden Start-Signal eingeschaltet und von dem vom ODER-Gatter 16 kommenden Stopp-Signal wieder ausgeschaltet. Beim Einschalten der Konstantstromquelle und gleichzeitigen Öffnen des parallel zum Ladekondensator liegenden Entladeschalters steigt die Spannung am Ladekondensator im wesentlichen linear an, was ein ebenso lineares Absinken des Kollektor- bzw. des entsprechenden Ladekondensatorplatten-Potentials zur Folge hat. Im Ruhezustand ist die Konstantstromquelle abgeschaltet und der Entladeschalter geschlossen.

Verwendet man die oben beschriebene ein- und ausschaltbare Konstantstromquelle als Ladeschaltung in der Zeit/Amplituden-Wandlerschaltung 14, so tritt nach einem Start der Zeit/Amplituden-Wandlerschaltung 14 nach einigen unvermeidlichen Anfangsstörungen, die in Fig. 4 mit dem Bezugszeichen 85 gekennzeichnet sind, ein mehr oder weniger linearer Anstieg der am Ladekondensator anliegenden Spannung $\Delta U_{aus}$ auf. Der geeichte Bereich der Kennlinie ist in der Fig. 4 durch die Punkte 90 und 91 gekennzeichnet. Der vordere durch eine Eichmessung erster Art gewonnene Punkt 90 hat vom Einschaltzeitpunkt $t_0$ der Zeit-Amplituden-Wandlerschaltung 14 einen Abstand von $3 \cdot T + \Delta t$, wobei $\Delta t$ die durch das Verzögerungsglied 38 eingeführte Verzögerung bedeutet. Der durch eine Eichmessung zweiter Art gewonnene Punkt 91 besitzt dagegen vom Zeitpunkt $t_0$ einen Abstand von $4 \cdot T + \Delta t$. Zwischen diese beiden Eichpunkte 90 und 91 ist eine Eichgerade 92 gelegt, und man sieht deutlich, daß der tatsächliche Kennlinienverlauf aufgrund der vorhandenen Nichtlinearitäten erheblich von dem idealen Verlauf der Eichgeraden 92 abweicht.

Bei der in Fig. 4 dargestellten Zeitabstandsmessung folgt der Verlauf der Ausgangsspannung $U_{aus}$ der Zeit/Amplituden-Wandlerschaltung nach dem mit der Flanke 84 zusammenfallenden Punkt 95 nicht mehr weiter dem dargestellten Kennlinienverlauf, sondern knickt horizontal ab, da durch das Stopp-Signal 84 die Konstantstromquelle in der Zeit/Amplituden-Wandler-Schaltung 14 ausgeschaltet wird und somit der Ladekondensator seine zu diesem Zeitpunkt erreichte Ausgangsspannung $\Delta U_{aus}$ solange beibe-

hält, bis dieser Ausgangssignalwert in die nachgeschaltete Sample-and-Hold-Schaltung 17 übernommen ist. Man sieht sehr deutlich, daß bei einer Berechnung des zwischen dem Einschaltzeitpunkt $t_0$ und dem Ausschaltzeitpunkt $t_1$ vergangenen Zeitraums aus dem Meßwert $\Delta U_{aus}$ und der Steigung der Eichgeraden 92 wegen der Nichtlinearität der tatsächlich wirksamen Kennlinie der Zeit/Amplituden-Wandlerschaltung 14 ein mit einem erheblichen Fehler behafteter Wert $t_2$ erhalten wird.

Führt man nun dieselbe Zeitabstandsmessung für ein anderes Einzelsignal durch, dessen Zeitabstand von dem Zeitabstand des in Fig. 4 wiedergegebenen Einzelsignals abgezogen werden soll, so wird im allgemeinen die zugehörige Abschaltflanke 84' an einer anderen Stelle des geeichten Kennlinienbereichs liegen, an der sich auch ein anderer Fehler t2'-t1' ergibt, so daß sich bei der nachfolgenden Subtraktion dieser beiden Zeitmeßwerte die Fehler t2-t1 und t2'-t1' nicht in ausreichendem Maße gegenseitig aufheben. Durch das erfindungsgemäße Verfahren wird demgegenüber durch die Wiederholung der jeweiligen Einzelsignale und die dabei mit Hilfe der unterschiedlichen Verzögerungen der Einzelsignale vorgenommene Verschiebung der Abschaltflanke 84 über den gesamten geeichten Kennlinienbereich hinweg dafür gesorgt, daß alle aufgrund der Nichtlinearität möglichen Fehler in den funktionalen Mittelwert einer Signalgruppe in etwa in gleichem Maße eingehen. Da dies für beide Signalgruppen gilt, deren Mittelwerte nachträglich voneinander subtrahiert werden, heben sich diese Fehlersummen nahezu vollständig bzw. vollständig gegenseitig auf.

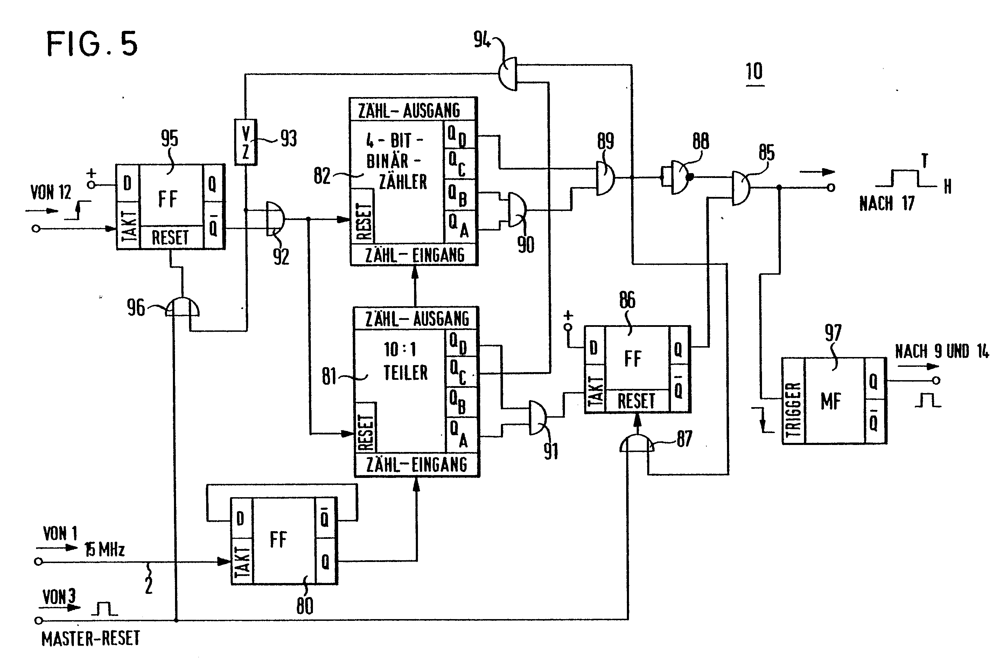

Um die bei den einzelnen Zeitabstandsmessungen und Eichmessungen am Ausgang der Zeit/Amplituden-Wandlerschaltung 14 gewonnenen Ausgangssignale nicht in sehr unterschiedlicher Weise mit einem vom Zeitbasissignal stammenden Störsignal zu verfälschen, wird der Übertrag dieser Ausgangsspannungen in die der Zeit/Amplituden-Wandlerschaltung 14 nachgeschaltete Sample-and-Hold-Schaltung 17 genau synchron mit dem Zeitbasissignal gesteuert. Hierzu dient die in Fig. 5 im einzelnen dargestellte Zwischenspeicher-Steuerung 10.

Wie man der Fig. 5 entnimmt, umfaßt eine bevorzugte Zwischenspeicher-Steuerung 10 eine Frequenz-Teileranordnung, die aus einem Flip-Flop 80, einem mit seinem Zähleingang mit dem Q-Ausgang des Flip-Flops 80 verbundenen 10 : 1-Teiler 81 und einem mit seinem Zähleingang mit dem Zählausgang des 10 : 1-Teilers 81 verbundenen 4-Bit-Binärzähler 82 besteht, wobei dem Takt-Eingang des Flip-Flops 80 das 15-MHz-Zeitbasissignal des Oszillators 1 zugeführt wird. Der $\overline{Q}$-Ausgang dieses Flip-Flops 80 ist mit dem D-Eingang dieses Flip-Flops verbunden, so daß das Flip-Flop 80 an seinem Q-Ausgang permanent Rechtecksignale mit einer Folgefrequenz von 7,5 MHz abgibt.

Die Ausgangssignale der Frequenzteiler-Anordnung werden mit Hilfe von UND-Gattern dekodiert, um zu geeigneten Zeiten ein Track-Hold-Signal geeigneter Länge für die Sample-and-Hold-Schaltung 17 zu erzeugen, wie dies im folgenden erläutert wird.

Solange kein Ausgangssignal der Zeit/Amplituden-Wandlerschaltung 14 in die Sample-and-Hold-Schaltung 17 übernommen werden soll, muß am Steuereingang der Sample-and-Hold-Schaltung 17 ein « Hold »-Signal, d. h. im vorliegenden Fall eine logische Null anliegen. Diese logische Null wird im Ruhezustand der Zwischenspeicher-Steuerung 10 von einem UND-Gatter 85 abgegeben, dessen einer Eingang vom Q-Ausgang eines Flip-Flops 86 mit einer logischen Null versorgt wird, da das Flip-Flop 86 über das ODER-Gatter 87 von einem vorausgegangenen, von der zentralen Rechen- und Ablaufsteuerungseinheit 3 abgegebenen Master-Rücksetzimpuls oder von einem von der Zwischenspeicher-Steuerung 10 selbst erzeugten Rücksetzimpuls zurückgesetzt worden ist. Der andere Eingang des UND-Gatters 85 ist mit dem Ausgang eines Inverters 88 verbunden, der bei dem betrachteten Ruhezustand eine logische Eins liefert, da das den Eingang des Inverters 88 ansteuernde UND-Gatter 89 an seinen beiden Eingängen eine logische Null empfängt und somit an seinem Ausgang eine logische Null abgibt.

Der eine Eingang des UND-Gatters 89 ist mit dem $Q_D$-Ausgang des 4-Bit-Binärzählers 82 verbunden, während der andere Eingang des UND-Gatters 89 mit dem Ausgang eines weiteren UND-Gatters 90 verbunden ist, dessen Eingänge mit dem $Q_B$- bzw. $Q_A$-Ausgang des 4-Bit-Binärzählers 82 verbunden sind. Da dieser Zähler 82 im betrachteten Ruhezustand über seinen Reset-Eingang im zurückgesetzten Zustand gehalten wird, weisen seine Ausgänge $Q_A$ bis $Q_D$ jeweils eine logische Null auf, was über die UND-Gatter 90 und 89 zu dem oben beschriebenen Ansteuerungszustand für den Inverter 88 führt.

Auch der 10 : 1-Teiler 81 wird im Ruhezustand der Zwischenspeicher-Steuerung 10 über seinen Reset-Eingang zwangsweise im zurückgesetzten Zustand gehalten, so daß auch an seinen Ausgängen $Q_A$ bis $Q_D$ jeweils eine logische Null vorhanden ist. Die Ausgänge $Q_A$ und $Q_D$ des 10 : 1-Teilers 81 sind mit den beiden Eingängen eines UND-Gatters 91 verbunden, dessen Ausgang mit dem Takt-Eingang des Flip-Flops 86 verbunden ist. Da im betrachteten Zeitraum den beiden Eingängen des UND-Gatters 91 jeweils eine logische Null zugeführt wird, liegt auch sein Ausgang auf einer logischen Null, so daß keine Ansteuerung des Flip-Flops 86 erfolgt.

Der den 10 : 1-Teiler 81 und den 4-Bit-Binärzähler 82 im zurückgesetzten Zustand haltende 1-Pegel wird von einem ODER-Gatter 92 geliefert, dessen einer Eingang über ein Verzögerungsglied 93 mit dem Ausgang eines UND-Gatters 94 verbunden ist, das eine logische Null liefert, weil sein einer Eingang mit dem eine logische Null liefernden $Q_C$-Ausgang des 10 : 1-Teilers 81 und sein anderer Eingang mit dem ebenfalls eine logische Null liefernden Ausgang des UND-Gatters 89 verbunden ist.

Der zweite Eingang des ODER-Gatters 92 ist mit dem $\overline{Q}$-Ausgang eines Flip-Flops 95 verbunden, das über ein seinen Rücksetz-Eingang ansteuerndes ODER-Gatter 96 entweder mit Hilfe eines vorausgegangenen Master-Rücksetzimpulses oder über einen von der Zwischenspeicher-Steuerung 10 selbst erzeugten Rücksetzimpuls zurückgesetzt worden ist, so daß sein $\overline{Q}$-Ausgang die logische 1 liefert, die vom ODER-Gatter 92 an die Rücksetzeingänge des 10 : 1-Teilers 81 und des 4-Bit-Binärzählers 82 weitergegeben wird.

Der Takt-Eingang des Flip-Flops 95 ist mit dem Ausgang des ODER-Gatters 12 verbunden, der auch mit dem Start-Eingang der Zeit/Amplituden-Wandlerschaltung 14 verbunden ist.

Liefert das ODER-Gatter 12 nun eine als Start-Signal für die Zeit/Amplituden-Wandlerschaltung 14 dienende steigende Flanke, so wird durch diese steigende Flanke auch das Flip-Flop 95 gesetzt, da dessen D-Eingang ständig auf logisch 1 liegt. Dieses Setzen des Flip-Flops 95 bewirkt einen Start der Zwischenspeicher-Steuerung 10, da ja nach dem Starten der Zeit/Amplituden-Wandlerschaltung 14 an deren Ausgang mit einer gewissen Verzögerung ein neuer Meßwert zu erwarten ist, der in die Sample-and-Hold-Schaltung 17 übernommen werden muß.

Diese Verzögerung wird mit Hilfe der Frequenzteiler-Anordnung 80, 81 und 82 erzeugt, was dadurch eingeleitet wird, daß die Rücksetzeingänge des 10 : 1-Teilers 81 und des 4-Bit-Binärzählers 82 durch das Anlegen einer logischen 0 freigegeben werden. Diese logische 0 entsteht dadurch, daß beim Zurücksezten des Flip-Flops 95 dessen $\overline{Q}$-Ausgang auf logisch 0 schaltet und somit an beiden Eingängen des ODER-Gatters 92 eine logische 0 anliegt.

Durch die Freigabe seines Rücksetz-Eingangs wird der 10 : 1-Teiler 81 in die Lage versetzt, auf die an seinem Zähleingang anliegenden, vom Flip-Flop 80 abgegebenen 7,5-MHz-Impulse zu reagieren. Nachdem er neun solche Impulse empfangen hat, d. h. also nach 18 Perioden des Zeitbasis-Signals und somit zu einem Zeitpunkt, in dem die Zeit/Amplituden-Wandlerschaltung 14 ihren Meßvorgang längst beendet hat und auch eventuell an ihrem Ausgang aufgrund des ihr zugeführten Stopp-Signals aufgetretene Störungen abgeklungen sind, erscheint gleichzeitig am $Q_A$- und am $Q_D$-Ausgang des 10 : 1-Teilers 81 eine logische 1, so daß auch das UND-Gatter 91 an seinem Ausgang von logisch 0 auf logisch 1 schaltet. Die dabei auftretende positive Flanke setzt das Flip-Flop 86, dessen D-Eingang ständig auf logisch 1 liegt. Dadurch erscheint am Q-Ausgang des Flip-Flops 86 eine logische 1 die über das UND-Gatter 85, an dessen anderem Eingang die vom Inverter 88 abgegebene logische 1 anliegt, an den Steuer-Eingang der Sample-and-Hold-Schaltung 17 als « Track »-Signal abgegeben wird, so daß diese beginnt, den am Ausgang der Zeit/Amplituden-Wandlerschaltung 14 anliegenden Meßwert zu übernehmen. Für diese Übernahme, die im wesentlichen dadurch geschieht, daß ein in der Sample-and-Hold-Schaltung 17 enthaltener Kondensator über einen endlichen Widerstand auf dieselbe Spannung aufgeladen wird, die am Ausgang der Zeit/Amplituden-Wandlerschaltung 14 anliegt, ist ein gewisser Mindestzeitraum erforderlich, der durch die Zeitkonstante des in Rede stehenden Ladekondensators und des zugehörigen Ladewiderstandes bestimmt ist. Diese Zeitkonstante kann nicht beliebig klein gewählt werden, da der von diesem Ladekondensator zwischengespeicherte analoge Spannungswert für die nachfolgende Analog/Digital-Wandlung für einen vorgegebenen Mindestzeitraum in möglichst unveränderter Form zur Verfügung stehen muß. Da jeder Kondensator einen seinen Ladezustand und damit die an ihm abfallende Spannung verändernden Leckstrom aufweist, der jedoch von der Kapazität des Kondensators weitgehend unabhängig ist, muß im vorliegenden Fall also ein Kondensator mit einer genügend großen Kapazität gewählt werden.

Ein Track-Signal ausreichender Länge wird dadurch erzeugt, daß der 4-Bit-Binärzähler 82 erst beim elften Ausgangsimpuls des 10 : 1-Teilers 81, d. h. erst nach 220 Perioden des 15-MHz-Zeitbasissignals gleichzeitig an seinem $Q_A$-, $Q_B$- und $Q_D$-Ausgang eine logische 1 erzeugt, die über die UND-Gatter 90 und 89 an den Eingang des Inverters 88 weitergegeben wird, der daraufhin an den entsprechenden Eingang des UND-Gatters 85 eine logische 0 anlegt, so daß das am Ausgang des UND-Gatters 85 erscheinende Steuersignal für die Sample-and-Hold-Schaltung 17 auf den « Hold »-Pegel abfällt. Der Zeitpunkt dieser fallenden Flanke, die den von der Sample-and-Hold-Schaltung übernommenen und für die nachfolgende Digitalisierung zwischengespeicherten Spannungswert festschreibt, ist über die Frequenzteileranordnung 80, 81, 82 und die UND-Gatter 90, 89, den Inverter 88 und das UND-Gatter 85 exakt mit dem 15-MHz-Zeitbasissignal korreliert. Zwar tritt eine gewisse zeitliche Verzögerung zwischen der genannten fallenden Flanke und der zugehörigen steigenden Flanke des 15-MHz-Zeitbasissignals ein, doch kann diese Verzögerung mit sehr guter Näherung zumindest in dem kurzen Zeitraum als konstant betrachtet werden, der erforderlich ist, um die voneinander zu subtrahierenden Meßwerte zweier Einzelsignalgruppen zu gewinnen. Durch diese zeitliche Synchronisation der am Ausgang des UND-Gatters 85 erscheinenden fallenden Flanke mit dem Zeitbasissignal wird erreicht, daß von diesem Zeitbasissignal stammende Störspannungen, die sich dem Ausgangssignal der Zeit/Amplituden-Wandlerschaltung 14 überlagern und daher von der Sample-and-Hold-Schaltung 17 mit übernommen werden, in jeden Meßwert mit derselben Amplitude eingehen und daher bei der nachfolgenden Subtraktion eliminiert werden.

Die am Ausgang des UND-Gatters 89 erscheinende logische 1 wird außerdem über das ODER-Gatter 87 an den Rücksetzeingang des Flip-Flops 86 gelegt, das dadurch zurückgesetzt wird. Die hierdurch an seinem Q-Ausgang erscheinende logische 0 bleibt zunächst ohne Wirkung, da das UND-Gatter 85 an seinem anderen Eingang ja ebenfalls eine logische 0 erhält.

Die am Ausgang des UND-Gatters 89 vorhandene logische 1 wird vom UND-Gatter 94 zunächst solange unterdrückt, bis der $Q_C$-Ausgang des 10 : 1-Teilers 81 nach den eben geschilderten Vorgängen zum ersten Mal wieder eine logische 1 abgibt. Dies ist nach weiteren acht Perioden des 15-MHz-Zeitbasissignals der Fall und da durch das zurückgesetzte Flip-Flop 86 sichergestellt ist, daß die am Ausgang des UND-Gatters 85 vorhandene logische 0 gehalten wird, können nunmehr durch die vom UND-Gatter 94 abgegebene logische 1 der 10 : 1-Teiler 81 und der 4-Bit-Binärzähler 82 über das ODER-Gatter 92 zurückgesetzt werden. Dabei sorgt das Verzögerungsglied 93 dafür, daß dieses Rücksetzsignal, das über das ODER-Gatter 96 auch das Flip-Flop 95 in den Ruhezustand bringt, eine ausreichende Länge besitzt.

Die zuvor beim Zurücksetzen des Flip-Flops 86 am Ausgang des UND-Gatters 85 aufgetretene fallende Flanke hat überdies ein Monoflop 97 getriggert, das an seinem Q-Ausgang einen Rücksetzimpuls erzeugt hat, der über die Leitung 19 (siehe Fig. 1) dem Rücksetzeingang der Zeit/Amplituden-Wandlerschaltung 14 und über das ODER-Gatter 9 dem Rücksetzeingang des Flip-Flops 8 zugeführt wird, so daß der gesamte Analogteil der erfindungsgemäßen Zeitmeßschaltung für den nächsten Meßvorgang bereit ist.

Abschließend sei noch darauf hingewiesen, daß dann, wenn die Einzelsignale nicht sehr rasch aufeinanderfolgen, die beim Ausführungbeispiel nach Fig. 2 von UND-Gattern 47 bis 54 gebildeten steuerbaren Schalter der steuerbaren Verzögerungsanordnung 5 vorteilhafterweise auch mit Relais realisiert werden können. Es sind Relais mit einer garantierten Schaltspielzahl von $10^9$ verfügbar, was eine ausreichende Lebensdauer garantiert. Ein wesentlicher Vorteil dieser Anordnung besteht darin, daß eine völlige Potentialtrennung erfolgt, so daß keine Reflexionen an zwar im Prinzip abgeschalteten aber doch nicht völlig voneinander getrennten Schaltungsteilen auftreten können. Diese Reflexionen haben bei der Verwendung von UND-Gattern als steuerbare Schalter zur Folge, daß die einzelnen Verzögerungsglieder bei an und für sich gleichen Signallaufzeiten in Abhängigkeit von ihrer Stellung innerhalb der Verzögerungskette unterschiedliche Verzögerungswerte liefern. Da aber, wie bereits erwähnt, Abweichungen von der Einheitsverzögerung $\tau_0$ von ± 30 % bei den eingangs genannten Genauigkeiten ohne weiteres akzeptiert werden können, wäre der Ersatz der UND-Gatter 47 bis 54 durch Relais allenfalls bei noch größeren geforderten Genauigkeiten nötig.

**Patentansprüche**

1. Zeitmeßverfahren, bei dem die Zeitabstände gemessen werden, die einerseits die Einzelsignale einer ersten Signalgruppe und andererseits die Einzelsignale einer zweiten Signalgruppe von einer jeweils zugehörigen, definierten Flanke eines periodischen Zeitbasissignals aufweisen, und bei dem für die Berechnung eines Meßwertes wenigstens eine Differenz zwischen dem gemessenen Zeitabstand eines Einzelsignals der einen Signalgruppe und dem gemessenen Zeitabstand eines zugehörigen Einzelsignals der anderen Signalgruppe verwendet wird, wobei diese Zeitabstände mit Hilfe derselben Zeit/Amplituden-Wandlerschaltung gemessen werden, der als Start-Signal das jeweilige Einzelsignal oder die definierte Flanke und als Stopp-Signal die definierte Flanke bzw. das jeweilige Einzelsignal zugeführt wird und die einen geeichten, wenigstens eine Periodenlänge des Zeitbasissignals umfassenden Kennlinienbereich aufweist, und wobei die Einzelsignale der einen Signalgruppe einer ersten gleichbleibenden Grundverzögerung und die Einzelsignale der anderen Signalgruppe einer zweiten gleichbleibenden Grundverzögerung unterliegen, dadurch gekennzeichnet, daß zur Erzielung eines Meßwertes für die eine Signalgruppe n Einzelsignale und für die andere Signalgruppe n Einzelsignale phasenstarr zum Zeitbasissignal erzeugt werden, daß für jede der beiden Signalgruppen eines der Einzelsignale der Zeit/Amplituden-Wandlerschaltung unverzögert und jedes der n — 1 restlichen Einzelsignale mit einer zusätzlichen Verzögerung zugeführt wird, die für jedes Einzelsignal einer Signalgruppe einen anderen Wert aufweist, daß die je Signalgruppe verwendeten n — 1 zusätzlichen Verzögerungswerte so gewählt werden, daß sie den geeichten Kennlinienbereich der Zeit/Amplituden-Wandlerschaltung in etwa gleichmäßig überdecken, und daß zur Meßwertbildung die gemittelte Differenz der für die beiden Signalgruppen gewonnenen Ausgangssignalwerte der Zeit/Amplituden-Wandlerschaltung verwendet wird.

2. Verfahren nach Anspruch 1, dadurch gekennzeichnet, daß jeweils ein Einzelsignal der einen und ein Einzelsignal der anderen Signalgruppe derselben zusätzlichen Verzögerung unterworfen wird.

3. Verfahren nach Anspruch 1 oder 2, dadurch gekennzeichnet, daß zuerst die zu einer Signalgruppe gehörenden Einzelsignale hintereinander erzeugt und die zugehörigen Ausgangssignalwerte der Zeit/Amplituden-Wandlerschaltung zwischengespeichert werden und daß dann die zur anderen Signalgruppe gehörenden Einzelsignale hintereinander erzeugt und die zugehörigen Ausgangssignalwerte der Zeit/Amplituden-Wandlerschaltung zwischengespeichert werden.

4. Verfahren nach Anspruch 1 oder 2, dadurch gekennzeichnet, daß alternierend immer ein Einzelsignal der einen und ein Einzelsignal der anderen Signalgruppe erzeugt wird und die zugehörigen Ausgangssignalwerte der Zeit/Amplituden-Wandlerschaltung zwischengespeichert werden.

5. Verfahren nach einem der Ansprüche 1 bis 4, dadurch gekennzeichnet, daß die Einzelsignale einer jeden Signalgruppe in solchen Zeitabständen erzeugt werden, daß die Zeit/Amplituden-Wandlerschaltung periodisch betrieben wird.

6. Verfahren nach einem der vorhergehenden Ansprüche, dadurch gekennzeichnet, daß der Zeit/Amplituden-Wandlerschaltung das erste Einzelsignal einer Signalgruppe unverzögert, das zweite mit einer Verzögerung $\tau_0$, das dritte mit einer Verzögerung $2 \cdot \tau_0$ usw. und schließlich das letzte mit einer Verzögerung $(n — 1) \cdot \tau_0$ zugeführt wird und daß n und $\tau_0$ so gewählt werden, daß $n \cdot \tau_0$ in etwa gleich der zeitlichen Länge des geeichten Kennlinienbereichs der Zeit/Amplituden-Wandlerschaltung ist.

7. Verfahren nach einem der vorhergehenden Ansprüche, dadurch gekennzeichnet, daß der Zeit/Amplituden-Wandlerschaltung bei den Zeitabstandsmessungen das jeweilige Einzelsignal als Startsignal und eine nachfolgende Flanke des Zeitbasissignals als Stopp-Signal zugeführt wird.

8. Verfahren nach einem der vorhergehenden Ansprüche, dadurch gekennzeichnet, daß das Zeitbasissignal mit Hilfe eines quarzgesteuerten Oszillators erzeugt und die Zeit/Amplituden-Wandlerschaltung mit Hilfe der Periodenlänge des Zeitbasissignals so geeicht wird, daß der geeichte Kennlinienbereich der Zeit/Amplituden-Wandlerschaltung durch zwei Eichmessungen definiert wird, wobei die Zeit/Amplituden-Wandlerschaltung bei jeder Eichmessung durch eine steigende oder fallende Flanke des Zeitbasissignals gestartet und durch eine nachfolgende steigende oder fallende Flanke des Zeitbasissignals angehalten wird, daß der Abstand zwischen den beiden als Start- bzw. Stopp-Signal dienenden Flanken bei der einen Eichmessung m und bei der anderen Eichmessung m + μ Perioden des Zeitbasissignals beträgt, und daß bei jeder Zeitabstandsmessung das Stopp-Signal der Zeit/Amplituden-Wandlerschaltung mit einer solchen Verzögerung zugeführt wird, daß die Zeit/Amplituden-Wandlerschaltung während eines in etwa wenigstens m und in etwa höchstens m + μ Perioden des Zeitbasissignals entsprechenden Zeitraums arbeitet.

9. Verfahren nach Anspruch 8, dadurch gekennzeichnet, daß bei den beiden Eichmessungen der Zeit/Amplituden-Wandlerschaltung das Stopp-Signal mit einer Zusatzverzögerung zugeführt wird, die in etwa gleich der Ansprechverzögerung der Schaltungsanordnung ist, mit deren Hilfe bei den Zeitabstandsmessungen erst die (m + μ)-te nach dem Startsignal auftretende Flanke des Zeitbasissignals als Stopp-Signal für die Zeit/Amplituden-Wandlerschaltung zugelassen wird.

10. Verfahren nach Anspruch 9, dadurch gekennzeichnet, daß m gleich 3 und μ gleich 1 gewählt wird.

11. Verfahren nach einem der Ansprüche 8 bis 10, dadurch gekennzeichnet, daß vor jeder Zeitabstandsmessung für ein Einzelsignal der einen Signalgruppe eine Eichmessung, bei der der Abstand zwischen dem Start- und dem Stopp-Signal m Perioden des Zeitbasissignals beträgt, und vor jeder Zeitabstandsmessung für ein Einzelsignal der anderen Signalgruppe eine Eichmessung, bei der der Abstand zwischen dem Start- und dem Stopp-Signal m + μ Perioden des Zeitbasissignals beträgt, durchgeführt wird und daß der Beginn einer jeden Eichmessung zeitlich so gesteuert wird, daß die Zeit/Amplituden-Wandlerschaltung und die ihr nachgeschaltete Zwischenspeichereinrichtung periodisch und phasenstarr zum Zeitbasissignal betrieben werden.

12. Zeitmeßvorrichtung mit einem ein periodisches Zeitbasissignal erzeugenden Oszillator (1), einer Zeit/Amplituden-Wandlerschaltung (14), mit deren Hilfe die Zeitabstände meßbar sind, die die von einer Generatoranordnung aufgrund jeweils eines Triggersignals erzeugten Einzelsignale einer ersten Signalgruppe und die von der Generatoranordnung aufgrund jeweils eines Triggersignals erzeugten Einzelsignale einer zweiten Signalgruppe von jeweils einer definierten Flanke des Zeitbasissignals aufweisen, wobei alle Einzelsignale der ersten Signalgruppe einer ersten gleichbleibenden Grundverzögerung und alle Einzelsignale der zweiten Signalgruppe einer zweiten gleichbleibenden Grundverzögerung unterliegen, mit einer die Differenz der Zeitabstände der Einzelsignale der ersten und der zweiten Signalgruppe bildenden und weiterverarbeitenden Rechen- und Steuerschaltung (3) und mit einer Eichsignale für die Zeit/Amplituden-Wandlerschaltung (14) erzeugenden Start-Stopp-Steuerung (35), dadurch gekennzeichnet, daß

die Rechen- und Steuerschaltung (3) zur Abgabe von Triggersignalen zur Erzeugung von n Einzelsignalen, die die erste Signalgruppe bilden, und von n Einzelsignalen, die die zweite Signalgruppe bilden, ausgebildet ist,

eine die Triggersignale der Rechen- und Steuerschaltung (3) mit dem Zeitbasissignal des Oszillators (1) in eine phasenstarre Beziehung bringende Synchronisationsschaltung (26) und

eine in jeder Signalgruppe eines der n Einzelsignale unverzögert durchlassende und die übrigen $n — 1$ Einzelsignale jeweils einer anderen Verzögerung unterwerfende, steuerbare Verzögerungsanordnung (5) vorgesehen sind,

die Werte der mit der steuerbaren Verzögerungsanordnung (5) erzielbaren $n — 1$ Verzögerungen so gewählt sind, daß die Summe von n solchen Werten gleich der zeitlichen Länge des geeichten Kennlinienbereichs der Zeit/Amplituden-Wandlerschaltung ist, und daß

die Rechen- und Speicherschaltung (3) zur Bildung der gemittelten Differenz der für die beiden Signalgruppen gewonnenen Ausgangssignalwerte der Zeit/Amplituden-Wandlerschaltung (14) ausgebildet ist.

13. Vorrichtung nach Anspruch 12, dadurch gekennzeichnet, daß die steuerbare Verzögerungsanordnung (5) $n — 1$ hintereinandergeschaltete Verzögerungsglieder (40 bis 46) umfaßt, von denen jedes in etwa denselben Verzögerungs-

wert $\tau_0$ liefert, wobei das zu verzögernde Signal dem ersten Verzögerungsglied (40) zuführbar ist, und daß vor dem ersten Verzögerungsglied (40), zwischen jedem Paar von aufeinanderfolgenden Verzögerungsgliedern (40, 41 ; 41, 42 ; 42, 43 ; 43, 44 ; 44, 45 ; 45, 46) und hinter dem letzten Verzögerungsglied (46) jeweils ein Abgriff vorgesehen ist, der über einen steuerbaren Schalter (47 bis 54) mit der Ausgangsleitung (6) der Verzögerungsanordnung (5) verbindbar ist, wobei jedes der n — 1 Verzögerungsglieder (40 bis 46) aus mehreren hintereinandergeschalteten Gattern besteht, die steuerbaren Schalter (47 bis 54) elektronische Schalter, insbesondere UND-Gatter, sind und zur Ansteuerung der steuerbaren Schalter (47 bis 54) ein Johnson-Zähler (56) vorgesehen ist.

14. Vorrichtung nach einem der Ansprüche 12 oder 13, dadurch gekennzeichnet, daß eine zwei Triggereingänge (E1, E2) sowie einen ein Eich-Start-Signal und einen ein Eich-Stopp-Signal für die Zeit/Amplituden-Wandlerschaltung (14) abgebenden Ausgang aufweisende Start-Stopp-Steuerung (35) so aufgebaut ist, daß die beiden mit dem Zeitbasissignal synchronisierten Ausgangssignale bei Ansteuerung des einen Triggereingangs (E1) gleichzeitig und bei Ansteuerung des anderen Triggereingangs (E2) um eine vorgegebene Anzahl von Perioden, insbesondere um eine Periode, des Zeitbasissignals gegeneinander versetzt abgegeben werden.

15. Vorrichtung nach Anspruch 14, dadurch gekennzeichnet, daß zwischen den das Stopp-Signal für die Zeit/Amplituden-Wandlerschaltung (14) abgebenden Ausgang der Start-Stopp-Steuerung (35) und die Zeit/Amplituden-Wandlerschaltung (14) eine das Stopp-Signal um eine vorgegebene ganze Anzahl von Perioden, insbesondere um drei Perioden, des Zeitbasissignals verzögernde zweite Flankenfreigabe-Schaltung (37) geschaltet ist, die insbesondere aus einer Kette von drei D-Flip-Flops (75, 76, 77) besteht, deren Takteingänge mit dem Zeitbasissignal angesteuert werden, während der D-Eingang des ersten Flip-Flops (75) der Kette mit dem Stopp-Signal-Ausgang der Start-Stopp-Steuerung (35) verbunden ist.

16. Vorrichtung nach einem der vorhergehenden Ansprüche, dadurch gekennzeichnet, daß durch das Ausgangssignal der steuerbaren Verzögerungsanordnung (5) ein Flip-Flop (8) setzbar ist, dessen Ausgangssignal als Startsignal für die Zeit/Amplituden-Wandlerschaltung (14) dient und eine erste Flankenfreigabe-Schaltung (15) triggert, die die $(m + \mu)$-te, insbesondere die vierte Flanke des Zeitbasissignals an den Stopp-Eingang der Zeit/Amplituden-Wandlerschaltung (14) legt.

17. Vorrichtung nach Anspruch 16, dadurch gekennzeichnet, daß die erste Flankenfreigabe-Schaltung (15) aus einer Kette von insbesondere vier D-Flip-Flops (58, 59, 60, 61) besteht, deren Takteingänge mit dem Zeitbasissignal angesteuert werden, während der D-Eingang des ersten Flip-Flops (58) der Kette mit einem Ausgang des der steuerbaren Verzögerungsanordnung (5) nachgeschalteten Flip-Flops (8) verbunden ist und daß zwischen den Ausgang der zweiten Flankenfreigabe-Schaltung (37) und den Stopp-Eingang der Zeit/Amplituden-Wandlerschaltung (14) ein Verzögerungsglied (38) eingeschaltet ist, dessen Verzögerung in etwa gleich der Ansprechverzögerung der Eingangsstufe (58) der ersten Flankenfreigabe-Schaltung (15) ist.

18. Vorrichtung nach einem der vorhergehenden Ansprüche, dadurch gekennzeichnet, daß für den das Ausgangssignal der Zeit/Amplituden-Wandlerschaltung (14) übernehmenden Zwischenspeicher (17) eine die Beendigung eines jeden Übernahmevorgangs mit dem Zeitbasissignal synchronisierende Zwischenspeicher-Steuerschaltung (10) vorgesehen ist.

19. Verfahren nach einem der Ansprüche 1 bis 11, bei dem zur Berechnung des Meßwertes die Differenz der Laufzeit des ersten und der Laufzeit des vom ersten getrennt erzeugten zweiten Einzelsignals verwendet wird, dadurch gekennzeichnet, daß zusätzlich zu den als Feinmeßwerten dienenden Zeitabständen der Einzelsignale von einer jeweils zugehörigen definierten Flanke des Zeitbasissignals für wenigstens ein erstes und ein zweites Einzelsignal, die beide derselben zusätzlichen Verzögerung unterworfen werden, jeweils ein Grobmeßwert durch Zählen der Perioden des Zeitbasissignals ermittelt wird, die zwischen einem mit der Erzeugung des jeweiligen Einzelsignals phasenstarr korrelierten Auslösesignal und der diesem Einzelsignal zugeordneten definierten Flanke des Zeitbasissignals auftreten, und daß die Laufzeitdifferenz aus der Differenz der wenigstens zwei Grobmeßwerte und der gemittelten Differenz der für die beiden Signalgruppen gewonnenen Feinmeßwerte berechnet wird.

### Claims

1. Time measuring method, in which the time distances are measured which have the individual signals of a first signal group on the one side, and the individual signals of a second signal group on the other side, from a respectively associated defined edge of a periodic time base signal, and in which at least one difference between the measured time distance of an individual time signal of the one signal group and the measured time distance of an associated individual signal of the other signal group is used for the calculation of a measurement value, wherein these time distances are measured with the aid of the same time-to-amplitude converter circuit, to which the respective individual signal or the defined edge is fed as a start signal and the defined edge or the respective individual signal is fed as a stop signal and which has a calibrated characteristic range comprising at least one period length of the time base signal, and wherein the individual signals of the one signal group are subjected to a first constant basic delay and the individual signals of the other signal group are subjected to a second constant basic delay, characterised in that, in order to obtain one measurement value, for the one signal group n individual signals and for the other signal group n individual signals are generated rigidly in phase with the time base signal, in that for each of the two signal groups one of the individual signals is fed undelayed and each of the remaining n — 1 individual signals is fed with an additional delay to the time-to-amplitude converter circuit, said additional delay having a different value for each individual signal of a signal group, in that the additional n — 1 delay values used for each signal group are so chosen that they cover the calibrated characteristic range of the time-to-amplitude converter circuit about uniformly, and in that the mean difference of the output signal values of the time-to-amplitude converter circuit, which are obtained for both the signal groups, is used for the measurement value formation.

2. Method according to claim 1, characterised in that an individual signal of the one and an individual signal of the other signal group are each time subjected to the same additional delay.

3. Method according to claim 1 or 2, characterised in that first the individual signals belonging to one signal group are generated one after the other and the associated output signal values of the time-to-amplitude converter circuit are intermediately stored and in that then the individual signals belonging to the other signal group are generated one after the other and the associated output signal values of the time-to-amplitude converter circuit are intermediately stored.

4. Method according to claim 1 or 2, characterised in that an individual signal of the one and an individual signal of the other signal group are always generated alternately and the associated output signal values of the time-to-amplitude converter circuit are intermediately stored.

5. Method according to one of the claims 1 to 4, characterised in that the individual signals of each signal group are generated at such time distances that the time-to-amplitude converter circuit is operated periodically.

6. Method according to one of the preceding claims, characterised in that the first individual signal of a signal group is fed undelayed, the second with a delay $\tau_0$, the third with a delay $2 \cdot \tau_0$ and so forth and finally the last with a delay of $(n — 1) \cdot \tau_0$ to the time-to-amplitude converter circuit and in that n and $\tau_0$ are so chosen that $n \cdot \tau_0$ is about equal to the temporal length of the calibrated characteristic range of the time-to-amplitude converter circuit.

7. Method according to one of the preceding claims, characterised in that for the time distance measurements, the respective individual signal is fed as start signal and a succeeding edge of the time base signal is fed as stop signal to the time-to-amplitude converter circuit.

8. Method according to one of the preceding claims, characterised in that the time base signal is generated with the aid of a quartz-controlled oscillator and the time-to-amplitude converter circuit is calibrated with the aid of the period length of the time base signal, in that the calibrated characteristic range of the time-to-amplitude converter circuit is defined by two calibration measurements, wherein, for each calibration measurement, the time-to-amplitude converter circuit is started by a rising or falling edge of the time base signal and is stopped by a succeeding rising or falling edge of the time base signal, in that the distance between the two edges serving as start signal and stop signal, respectively, amounts to m periods of the time base signal for the one calibration measurement and to m + $\mu$ periods of the time base signal for the other calibration measurement, and in that the stop signal is fed to the time-to-amplitude converter circuit on each time distance measurement with such a delay that the time-to-amplitude converter circuit operates for a period of time corresponding to at least about m and at most about m + $\mu$ periods of the time base signal.

9. Method according to claim 8, characterised in that for both the calibration measurements, the stop signal is fed to the time-to-amplitude converter circuit with an additional delay which is about equal to the response delay of the circuit arrangement, with the aid of which, in the time distance measurements, only the (m + $\mu$)th edge of the time base signal appearing after the start signal is admitted as stop signal for the time-to-amplitude converter circuit.

10. Method according to claim 9, characterised in that m is chosen to be equal to 3 and $\mu$ is chosen to be equal to 1.

11. Method according to one of the claims 8 to 10, characterised in that a calibration measurement is performed in which the distance between the start signal and the stop signal amounts to m periods of the time base signal before each time distance measurement for an individual signal of the one signal group and a calibration measurement is performed in which the distance between the start signal and the stop signal amounts to m + $\mu$ periods of the time base signal before each time distance measurement for an individual signal of the other signal group, and in that the beginning of each calibration measurement is so controlled in time that the time-to-amplitude converter circuit and the intermediate storage equipment connected therebehind are operated periodically and rigidly in phase with the time base signal.

12. Time measuring apparatus with an oscillator (1) generating a periodic time base signal, a time-to-amplitude converter circuit (14), with the aid of which the time distances from a defined edge of the time base signal are measurable which are exhibited by the individual signals of a first signal group each of which is generated by a generator arrangement by reason of a respective trigger signal and by the individual signals of a second signal group each of which is generated by the generator arrangement by reason of a respective trigger signal, wherein all the individual signals of the first signal group are subjected to a first constant basic delay and all the individual signals of the second signal group are subjected to a second constant basic delay, with an arithmetic and control circuit (3) forming and further processing the difference of the time distances of the individual signals of the first and the second signal group, and with a start-stop control (35) generating calibrating signals for the time-to-amplitude converter circuit (14), characterised in that

the arithmetic and control circuit (3) is designed for the delivery of trigger signals for the generation of n individual signals forming the first signal group, and of n individual signals forming the second signal group,

there are provided a synchronising circuit (26), which brings the trigger signals of the arithmetic and control circuit (3) into a rigid phase relationship with the time base signal of the oscillator (1), and

a controllable delay arrangement (5), which lets through undelayed one of the n individual signals of each signal group and subjects the n — 1 remaining individual signals each to a different delay,

the values of the n — 1 delays attainable by the controllable delay arrangement (5) are so chosen that the sum of n such values is equal to the temporal length of the calibrated characteristic range of the time-to-amplitude converter circuit, and in that

the arithmetic and control circuit (3) is designed for the formation of the mean difference of the output signal values of the time-to-amplitude converter circuit (14), which are obtained for both the signal groups.

13. Apparatus according to claim 12, characterised in that the controllable delay arrangement (5) comprises n — 1 delay members (40 to 46), which are connected one behind the other and each of which provides about the same delay value $\tau_0$, wherein the signal to be delayed is feedable to the first delay member (40), and in that a respective tap, which is connectable through a controllable switch (47 to 54) with the output line (6) of the delay arrangement (5), is provided before the first delay member (40), between each pair of successive delay members (40, 41 ; 41, 42 ; 42, 43 ; 43, 44 ; 44, 45 ; 45, 46) and behind the last delay member (46), wherein each of the n — 1 delay members (40 to 46) consists of several gates connected one behind the other, wherein the controllable switches (47 to 54) are electronic switches, particularly AND-gates, and wherein a Johnson counter (56) is provided for driving the controllable switches (47 to 54).

14. Apparatus according to one of the claims 12 or 13, characterised in that a start-stop control (35), which has two trigger inputs (E1, E2) as well as an output delivering a calibration start signal and an output delivering a calibration stop signal for the time-to-amplitude converter circuit (14), is so designed that both the output signals synchronised with the time base signal are delivered at the same time on driving the one trigger input (E1) and displaced one relative to the other by a predetermined number of periods, particularly by one period, of the time base signal on driving the other trigger input (E2).

15. Apparatus according to claim 14, characterised in that between the output of the start-stop control (35) delivering the stop signal for the time-to-amplitude converter circuit (14) and the time-to-amplitude converter circuit (14), a second edge release circuit (37) is connected, which delays the stop signal by a predetermined whole number of periods, particularly by three periods, of the time base signal and which, in particular, consists of a chain of three D-flip-flops (75, 76, 77), the clock inputs of which are driven by the time base signal, while the D-input of the first flip-flop (75) of the chain is connected with the stop signal output of the start-stop control (35).

16. Apparatus according to one of the preceding claims, characterised in that a flip-flop (8), the output signal of which serves as start signal for the time-to-amplitude converter circuit (14) and triggers a first edge release circuit (15), which applies the $(m + \mu)$th, particularly the fourth, edge of the time base signal to the stop input of the time-to-amplitude converter circuit (14), is settable by the output signal of the controllable delay arrangement (5).

17. Apparatus according to claim 16, characterised in that the first edge release circuit (15) consists of a chain of, in particular, four, D-flip-flops (58, 59, 60, 61), the clock inputs of which are driven by the time base signal, while the D-input of the first flip-flop (58) of the chain is connected with an output of the flip-flop (8) connected behind the controllable delay arrangement (5), and in that, between the output of the second edge release circuit (37) and the stop input of the time-to-amplitude converter circuit (14), a delay member (38) is connected, the delay of which is about equal to the response delay of the input stage (58) of the first edge release circuit (15).

18. Apparatus according to one of the preceding claims, characterised in that an intermediate store control circuit (10), which synchronises the termination of each take-over operation with the time base signal, is provided for the intermediate store (17) taking over the output signal of the time-to-amplitude converter circuit (14).

19. Method according to one of the claims 1 to 11, in which the difference between the transit time of the first individual signal and the transit time of the second individual signal generated separately from the first is used for the calculation of the measurement value, characterised in that additionally to the time distances, serving as fine measurement values, of the individual signals from a respectively associated defined edge of the time base signal, a respective coarse measurement value for at least one first and one second individual signal, which are both subjected to the same additional delay, is determined by counting the periods of the time base signal, which occur between an initiating signal correlated rigidly in phase with the generation of the respective individual signal and that defined edge of the time base signal, which is associated with this individual signal, and in that the transit time difference is calculated from the difference between the at least two coarse measurement values and the mean difference of the fine measurement values obtained for both the signal groups.

## Revendications

1. Méthode de mesure de temps dans laquelle on mesure les intervalles de temps que présentent, d'une part, les signaux individuels d'un premier groupe de signaux et, d'autre part, les signaux individuels d'un deuxième groupe de signaux relativement à un flanc défini chaque fois correspondant d'un signal de base de temps périodique et dans lequel, pour le calcul d'une valeur mesurée, on utilise au moins une différence entre l'intervalle de temps mesuré d'un signal individuel d'un groupe de signaux et l'intervalle de temps mesuré d'un signal individuel correspondant de l'autre groupe de signaux, en mesurant ces intervalles de temps à l'aide du même circuit transducteur temps/amplitude auquel on amène comme signal de démarrage le signal individuel considéré ou le flanc défini et comme signal d'arrêt le flanc défini ou le signal individuel considéré et qui présente une région de courbe caractéristique étalonnée comprenant au moins une longueur de période du signal de base de temps, les signaux individuels de l'un des groupes de signaux étant soumis à un premier retard de base constant et les signaux individuels de l'autre groupe de signaux à un deuxième retard de base constant, caractérisé en ce que pour obtenir une valeur mesurée, on engendre, de façon rigide en phase par rapport au signal de base de temps, pour l'un des groupes de signaux n signaux individuels et pour l'autre groupe de signaux, n signaux individuels, en ce que pour chacun des deux groupes de signaux on amène au circuit transducteur temps/amplitude l'un des signaux individuels sans retard de chacun des n — 1 signaux individuels restants avec un retard supplémentaire qui présente pour chaque signal individuel d'un groupe de signaux une valeur différente, en ce que l'on choisit les n — 1 valeurs de retard supplémentaires utilisées pour chaque groupe de signaux de façon telle qu'elles recouvrent à peu près uniformément la région de courbe caractéristique étalonnée du circuit transducteur temps/amplitude, et en ce que pour former la valeur mesurée, on utilise la différence moyenne des valeurs de signal de sortie du circuit transducteur temps/amplitude, obtenues pour les deux groupes de signaux.

2. Méthode selon la revendication 1, caractérisée en ce que l'on soumet chaque fois au même retard supplémentaire un signal individuel de l'un et un signal individuel de l'autre des groupes de signaux.

3. Méthode selon l'une des revendications 1 et 2, caractérisée en ce que l'on engendre tout d'abord successivement les signaux individuels appartenant à un groupe de signaux, en ce que l'on mémorise de façon intermédiaire les valeurs correspondantes de signal de sortie du circuit transducteur temps/amplitude, en ce qu'alors, on engendre successivement les signaux individuels appartenant à l'autre groupe de signaux, et en ce que l'on mémorise de façon intermédiaire les valeurs correspondantes de signal de sortie du circuit transducteur temps/amplitude.

4. Méthode selon l'une des revendications 1 à 2, caractérisée en ce qu'alternativement, on engendre toujours un signal individuel de l'un et un signal individuel de l'autre des groupes de signaux, et en ce que l'on mémorise de façon intermédiaire les valeurs correspondantes de signal de sortie du circuit transducteur temps/amplitude.

5. Méthode selon l'une des revendications 1 à 4, caractérisée en ce que l'on engendre les signaux individuels de chacun des groupes de signaux à des intervalles de temps tels que le circuit transducteur temps/amplitude soit actionné périodiquement.

6. Méthode selon l'une des revendications précédentes, caractérisée en ce que l'on amène au circuit transducteur temps/amplitude le premier signal individuel d'un groupe de signaux sans retard, le deuxième avec un retard $\tau_0$, le troisième avec un retard $2 \cdot \tau_0$ etc. et enfin le dernier avec un retard $(n — 1) \cdot \tau_0$, et en ce que l'on choisit n et $\tau_0$ de façon telle que $n \cdot \tau_0$ soit à peu près égal à la longueur, dans le temps, de la région de courbe caractéristique étalonnée du circuit transducteur temps/amplitude.

7. Méthode selon l'une des revendications précédentes, caractérisée en ce que l'on amène au circuit transducteur temps/amplitude, lors des mesures d'intervalle de temps, le signal individuel considéré en tant que signal de démarrage et un flanc suivant du signal de base de temps en tant que signal d'arrêt.

8. Méthode selon l'une des revendications précédentes, caractérisée en ce que l'on engendre le signal de base de temps à l'aide d'un oscillateur commandé par quartz, en ce que l'on étalonne le circuit transducteur temps/amplitude, à l'aide de la longueur de période du signal de base de temps, de façon telle que la région de courbe caractéristique étalonnée du circuit transducteur temps/amplitude soit définie par deux mesures d'étalonnage, le circuit transducteur temps/amplitude étant mis en marche lors de chaque mesure d'étalonnage par un flanc ascendant ou descendant du signal de base de temps et étant arrêté par un flanc ascendant ou descendant suivant du signal de base de temps, en ce que l'intervalle entre les deux flancs servant de signal de démarrage et d'arrêt représente, lors de l'une des mesures d'étalonnage, m et lors de l'autre mesure d'étalonnage $m + \mu$ périodes du signal de base de temps, et en ce que lors de chaque mesure d'intervalle de temps, le signal d'arrêt est amené au circuit transducteur temps/amplitude avec un retard tel que le circuit transducteur temps/amplitude fonctionne pendant un laps de temps correspondant à peu près au minimum à m et à peu près au maximum à m + μ périodes du signal de base de temps.

9. Méthode selon la revendication 8, caractérisée en ce que lors des deux mesures d'étalonnage, le signal d'arrêt est amené au circuit transducteur temps/amplitude avec un retard supplémentaire qui est à peu près égal au retard de réponse de la disposition de circuit à l'aide de laquelle, lors des mesures d'intervalle de temps, on admet seulement, comme signal d'arrêt pour le circuit transducteur temps/amplitude, le (m + μ)-ième flanc du signal de base de temps qui se produit après le signal de démarrage.

10. Méthode selon la revendication 9, caractérisée en ce que l'on choisit m égal à 3 et μ égal à 1.

11. Méthode selon les revendications 8 à 10, caractérisée en ce qu'avant chaque mesure d'intervalle de temps pour un signal individuel de l'un des groupes de signaux, on effectue une mesure d'étalonnage dans laquelle l'intervalle entre les signaux de démarrage et d'arrêt représente m périodes du signal de base de temps et qu'avant chaque mesure d'intervalle de temps pour un signal individuel de l'autre groupe de signaux, on effectue une mesure d'étalonnage dans laquelle l'intervalle entre les signaux de démarrage et d'arrêt représente m + μ périodes du signal de base de temps, et en ce que l'on commande dans le temps le début de chacune des mesures d'étalonnage de façon telle que le circuit transducteur temps/amplitude et le dispositif de mémoire intermédiaire branché après celui-ci soient actionnés périodiquement et de façon rigide en phase par rapport au signal de base de temps.

12. Dispositif de mesure de temps muni d'un oscillateur (1) engendrant un signal périodique de base de temps, d'un circuit transducteur temps/amplitude (14) à l'aide duquel on peut mesurer les intervalles de temps que présentent les signaux individuels d'un premier groupe de signaux, engendrés par un dispositif générateur chaque fois en vertu d'un signal de déclenchement et les signaux individuels d'un deuxième groupe de signaux, engendrés par le dispositif générateur chaque fois en vertu d'un signal de déclenchement, chaque fois relativement à un flanc défini du signal de base de temps, tous les signaux individuels du premier groupe de signaux étant soumis à un premier retard de base constant et tous les signaux individuels du deuxième groupe de signaux à un deuxième retard de base constant, d'un circuit de calcul et de commande (3) formant et traitant ensuite la différence des intervalles de temps des signaux individuels du premier et du deuxième groupes de signaux, et d'une commande démarrage-arrêt (35) engendrant des signaux d'étalonnage pour le circuit transducteur temps/amplitude (14), caractérisé en ce que

le circuit de calcul et de commande (3) est conçu pour fournir des signaux de déclenchement pour engendrer n signaux individuels qui forment le premier groupe de signaux et n signaux individuels qui forment le deuxième groupe de signaux,

en ce qu'il est prévu qu'un circuit de synchronisation (26) amenant à une relation rigide en phase les signaux de déclenchement du circuit de calcul et de commande (3) avec le signal de base de temps de l'oscillateur (1), et

un dispositif de retard (5) pouvant être commandé laissant passer sans retard dans chaque groupe des signaux l'un des n signaux individuels et soumettant les autres n — 1 signaux individuels à un retard chaque fois différent, en ce que

les valeurs des n — 1 retards que l'on peut obtenir avec le dispositif de retard (5) pouvant être commandé sont choisies de telle sorte que la somme de n de ces valeurs est égale à la longueur, dans le temps, de la région de courbe caractéristique étalonnée du circuit transducteur temps/amplitude, et en ce que

le circuit de calcul et de commande (3) est conçu pour former la différence moyenne des valeurs de signal de sortie du circuit transducteur temps/amplitude (14), obtenues pour les deux groupes de signaux.

13. Dispositif selon la revendication 12, caractérisé en ce que le dispositif de retard pouvant être commandé (5) comprend n — 1 organes de retard branchés à la suite les uns des autres (40 à 46) dont chacun fournit à peu près la même valeur de retard $\tau_0$, le signal à retarder pouvant être amené au premier organe de retard (40), et en ce qu'avant le premier organe de retard (40), entre chaque paire d'organes de retard successifs (40, 41 ; 41, 42 ; 42, 43 ; 43, 44 ; 44, 45 ; 45, 46) et derrière le dernier organe de retard (46) est chaque fois prévue une prise qui peut être reliée, par l'intermédiaire d'un interrupteur pouvant être commandé (47 à 54), à la ligne de sortie (6) du dispositif de retard (5), chacun des n — 1 organes de retard (40 à 46) étant formé de plusieurs portes branchées à la suite les unes des autres, les interrupteurs pouvant être commandés (47 à 54), étant des interrupteurs électroniques, en particulier des portes ET, et un compteur Johnson (56) étant prévu pour commander les interrupteurs pouvant être commandés (47 à 54).

14. Dispositif selon l'une des revendications 12 et 13, caractérisé en ce qu'une commande de démarrage et d'arrêt (35) présentant deux entrées de déclenchement (E1, E2) ainsi qu'une sortie fournissant un signal de démarrage d'étalonnage et une sortie fournissant un signal d'arrêt d'étalonnage pour le circuit transducteur temps/amplitude (14) est constituée de telle sorte que lorsque l'une des entrées de déclenchement (E1) est commandée, les deux signaux de sortie synchronisés avec le signal de base de temps sont émis simultanément, et en ce que lorsque l'autre entrée de déclenchement (E2) est commandée, ils sont émis avec un décalage mutuel d'un nombre prescrit de périodes, en particulier d'une période, du signal de base de temps.

15. Dispositif selon la revendication 14, caractérisé en ce qu'entre la sortie de la commande démarrage-arrêt (35) qui émet le signal d'arrêt pour le circuit transducteur temps/amplitude (14) et le circuit transducteur temps/amplitude (14) est branché un deuxième circuit de libération de flanc (37) retardant le signal d'arrêt d'un nombre entier prescrit de périodes, en particulier de trois périodes, du signal de base de temps, et qui est formé en particulier d'une chaîne de trois bascules D (75, 76, 77) dont les entrées de rythme sont commandées par le signal de base de temps, tandis que l'entrée D de la première bascule (75) de la chaîne est reliée à la sortie de signal d'arrêt de la commande démarrage-arrêt (35).

16. Dispositif selon l'une des revendications précédentes, caractérisé en ce que par le signal de sortie du dispositif de retard pouvant être commandé (5) peut être mise une bascule (8) dont le signal de sortie sert de signal de démarrage pour le circuit transducteur temps/amplitude et déclenche un premier circuit de libération de flanc (15) qui applique le (m + μ)-ième, en particulier le quatrième flanc du signal de base de temps à l'entrée d'arrêt du circuit transducteur temps/amplitude (14).

17. Dispositif selon la revendication 16, caractérisé en ce que le premier circuit de libération de flanc (15) est formé d'une chaîne de bascules D, en particulier quatre (58, 59, 60, 61) dont les entrées de rythme sont commandées par le signal de base de temps, tandis que l'entrée D de la première bascule (58) de la chaîne est reliée à une sortie de la bascule (8) branchée après le dispositif de retard pouvant être commandé (5), et en ce qu'entre la sortie du deuxième circuit de libération de flanc (37) et l'entrée d'arrêt du circuit transducteur temps/amplitude (14) est interposé un organe de retard (38) dont le retard est à peu près égal au retard de réponse de l'étage d'entrée (58) du premier circuit de libération de flanc (15).

18. Dispositif selon l'une des revendications précédentes, caractérisé en ce que pour la mémoire intermédiaire (17) reprenant le signal de sortie du circuit transducteur temps/amplitude (14) est prévu un circuit de commande de mémoire intermédiaire (10) synchronisant l'achèvement de chacun des processus de reprise avec le signal de base de temps.

19. Méthode selon l'une des revendications 1 à 11, dans laquelle, pour le calcul de la valeur mesurée, on utilise la différence du temps de propagation du premier signal individuel et du temps de propagation du deuxième signal individuel engendré séparément du premier, caractérisée en ce qu'en plus des intervalles de temps des signaux individuels, servant de valeurs mesurées précises, par un flanc défini chaque fois correspondant du signal de base de temps, par comptage des périodes du signal de base de temps qui apparaissent entre un signal de déclenchement en corrélation de façon rigide en phase avec la production du signal individuel considéré et le flanc du signal de base de temps adjoint à ce signal individuel, est déterminée une valeur mesurée grossière pour chacun d'au moins un premier et un deuxième signaux individuels qui sont tous deux soumis au même retard supplémentaire, et en ce que l'on calcule la différence de temps de propagation en partant de la différence des valeurs mesurées grossières au nombre d'au moins deux et de la différence moyenne des valeurs mesurées précises obtenues pour les deux groupes de signaux.

FIG.1

# FIG. 2

FIG. 3

FIG.4

FIG. 5